# EUROPEAN PATENT APPLICATION

(11) **EP 4 418 838 A1**
(43) Date of publication of application: **21.08.2024**
(21) Application number: 24156793.2
(22) Date of filing: 09.02.2024
(51) Int. Cl.: H10K 59/122, H10K 59/80

(54) **DISPLAY PANEL AND METHOD FOR MANUFACTURING THE SAME**

(30) Priority: 14.02.2023 KR 20230019319
(71) Applicant: Samsung Display Co., Ltd., Yongin-si, Gyeonggi-do 17113 (KR)
(72) Inventor: BAE, Chulmin, Yongin-si (KR); JO, Jungyun, Yongin-si (KR); HAN, Jihye, Yongin-si (KR); CHUNG, Yung Bin, Yongin-si (KR)
(74) Representative: Marks & Clerk LLP

(57) **Abstract**

A display panel includes a base layer, a pixel defining layer which is disposed on the base layer and in which a light emitting opening is defined, a partition wall which is disposed on the pixel defining layer and in which a partition wall opening corresponding to the light emitting opening is defined, and a light emitting element including an anode, an intermediate layer, and a cathode that is in contact with the partition wall, the light emitting element being disposed in the partition wall opening. The partition wall includes a first partition wall layer disposed on the pixel defining layer and including a metal, and a second partition wall layer disposed on the first partition wall layer and including at least one of amorphous carbon, polycrystalline silicon, or n-type silicon.

## Description

### BACKGROUND

### 1. Field

The disclosure herein relates to a display panel and a method for manufacturing the same, and more particularly, to a display panel having improved display quality.

### 2. Description of the Related Art

Display devices such as televisions, monitors, smart phones, and tablets that provide images to a user include display panels that display images. Various display panels such as liquid crystal display panels, organic light emitting display panels, electro wetting display panels, and electrophoretic display panels are being developed as the display panel.

An organic light emitting display panel may include an anode, a cathode, and a light emitting pattern. The light emitting pattern in an emission area may be separated from another light emitting pattern in another emission area, and the cathode may provide a common voltage to each emission area.

### SUMMARY

The disclosure provides a display panel having improved display quality, in which a light emitting element is formed without using a metal mask, and a method for manufacturing the same.

An embodiment of the inventive concept provides a display panel comprising: a base layer; a pixel defining layer which is disposed on the base layer and in which a light emitting opening is defined; a partition wall which is disposed on the pixel defining layer and in which a partition wall opening corresponding to the light emitting opening is defined; and a light emitting element including an anode, an intermediate layer, and a cathode that is in contact with the partition wall, the light emitting element being disposed in the partition wall opening, wherein the partition wall includes: a first partition wall layer disposed on the pixel defining layer and including a metal; and a second partition wall layer disposed on the first partition wall layer and including at least one of amorphous carbon, polycrystalline silicon, or n-type silicon.

In an embodiment, the partition wall may further include a third partition wall layer disposed on the second partition wall layer and including a metal or a silicon-based compound.

In an embodiment, the third partition wall layer may include or consist of titanium.

In an embodiment, the third partition wall layer may include or consist of at least one of silicon oxide, silicon nitride, or silicon oxynitride.

In an embodiment, the partition wall opening may include: a first area on which the light emitting element is disposed; and a second area having a width less than that of the first area, wherein an inner surface of the second partition wall layer may define the first area, and an inner surface of the third partition wall layer may define the second area.

In an embodiment, the third partition wall layer may have an undercut shape protruding from one side of the second partition wall layer. In an embodiment, the second and/or first partition layers may each have an undercut shape relative to the third partition wall layer such that the third partition wall layer protrudes from one side of the first and/or second partition wall layers.

In an embodiment, the first partition wall layer may have a thickness of about 1,000 angstroms or more and about 2,500 angstroms or less, and/or the second partition wall layer may have a thickness of about 4,000 angstroms or more and about 5,000 angstroms or less.

In an embodiment, the first partition wall layer may include or consist of aluminum.

In an embodiment, the first partition wall layer may be directly disposed (or disposed directly) on the pixel defining layer, and/or the second partition wall layer may be directly disposed (or disposed directly) on the first partition wall layer.

In an embodiment, the second partition wall layer may include a first sub partition wall layer and a second sub partition wall layer disposed on the first sub partition wall layer, and optionally the partition wall may further include an intermediate inorganic layer disposed between the first sub partition wall layer and the second sub partition wall layer.

In an embodiment, the display panel may further include a sacrificial pattern which is disposed between the anode and the pixel defining layer and in which a sacrificial opening overlapping the light emitting opening is defined.

In an embodiment, the cathode may be in contact with the second partition wall layer.

In an embodiment, the display panel may further include a thin film encapsulation layer disposed on the light emitting element and including a plurality of thin films, and optionally wherein the thin film encapsulation layer may include an encapsulation inorganic pattern which cover the light emitting element and of which a portion is in contact with the partition wall.

In an embodiment, an inner surface of the first partition wall layer and an inner surface of the second partition wall layer may be aligned.

In an embodiment, the pixel defining layer may include or consist of at least one of silicon oxide, silicon nitride, or silicon oxynitride.

In an embodiment of the inventive concept, a display panel includes: a base layer; a pixel defining layer which is disposed on the base layer and in which a light emitting opening is defined; a partition wall which is disposed on the pixel defining layer and in which a partition wall opening corresponding to the light emitting opening is defined; and a light emitting element including an anode, an intermediate layer, and a cathode that is in contact with the partition wall, the light emitting element being disposed in the partition wall opening, wherein the partition wall includes: a first partition wall layer disposed on the pixel defining layer and including a metal; a second partition wall layer disposed on the first partition wall layer and including a conductive inorganic material; and a third partition wall disposed on the second partition wall layer and including a metal or a silicon-based compound.

In an embodiment, an inner surface of the first partition wall layer may be closer to a center of the anode than an inner surface of the second partition wall layer is to the center of the anode.

In an embodiment of the inventive concept, a method for manufacturing a display panel comprises: providing a preliminary display panel including a base layer, an anode disposed on the base layer, a pixel defining layer disposed on the base layer and defining a light emitting opening through which a portion of the anode is exposed; forming a first preliminary partition wall layer including a metal on the preliminary display panel; forming a second preliminary partition wall layer including at least one of amorphous carbon, polycrystalline silicon, or n-type silicon on the first preliminary partition wall layer; forming a third preliminary partition wall layer including a metal or a silicon-based compound on the second preliminary partition wall layer; etching the first to third preliminary partition wall layers and forming a partition wall in which a partition wall opening is defined; and forming a light emitting pattern and a cathode that is in contact with the partition wall in the partition wall opening.

In an embodiment, the etching of the first to third preliminary partition wall layers and the forming the partition wall in which the partition wall opening is defined may include: primarily etching the first to third preliminary partition wall layers; and secondarily etching the first preliminary partition wall layer and the second preliminary partition wall layer and forming a first partition wall layer, a second partition wall layer, and a third partition wall layer, wherein an inner surface of the third partition wall layer may be closer to a center of the anode than an inner surface of the second partition wall layer is to the center of the anode.

In an embodiment, the first preliminary partition wall layer may include or consist of aluminum, and the third preliminary partition wall layer may include or consist of titanium.

At least some of the above and other features of the invention are set out in the claims.

### BRIEF DESCRIPTION OF THE DRAWINGS

The accompanying drawings are included to provide a further understanding of the inventive concept, and are incorporated in and constitute a part of this specification. The drawings illustrate embodiments of the inventive concept and, together with the description, serve to explain principles of the inventive concept. In the drawings:
FIG. 1A is a coupling perspective view of an embodiment of a display device according to the inventive concept;
FIG. 1B is an exploded perspective view of an embodiment of the display device according to the inventive concept;
FIG. 2 is a cross-sectional view of an embodiment of a display module in an embodiment of the disclosure;
FIG. 3 is a plan view of an embodiment of the display panel according to the inventive concept;
FIG. 4 is an equivalent circuit diagram of an embodiment of a pixel according to the inventive concept;
FIG. 5 is an enlarged plan view illustrating an embodiment of a portion of a display area of the display panel according to the inventive concept;
FIG. 6 is a cross-sectional view of an embodiment of the display panel according to the inventive concept;
FIGS. 7A to 7C are cross-sectional views illustrating an embodiment of a portion of a configuration of the display panel according to the inventive concept;
FIG. 8 is a cross-sectional view of an embodiment of the display panel according to the inventive concept; and
FIGS. 9A to 9I are cross-sectional views illustrating an embodiment of some processes of a method for manufacturing a display panel according to the inventive concept.

### DETAILED DESCRIPTION

Hereinafter, embodiments of the inventive concept will be described with reference to the accompanying drawings.

In this specification, it will also be understood that when one component (or region, layer, portion, etc.) is referred to as being 'on', `connected to', or `coupled to' another component, it can be directly connected/coupled on/to the one component, or an intervening third component may also be present.

Like reference numerals refer to like elements throughout. Also, in the drawing figures, the thickness, ratio, and dimensions of components are exaggerated for clarity of illustration. The term "and/or" includes any and all combinations of one or more of the associated listed items.

It will be understood that although the terms such as 'first' and 'second' are used herein to describe various elements, these elements should not be limited by these terms. These terms are used only to distinguish one component from other components. For example, a first element referred to as a first element in an embodiment can be referred to as a second element in another embodiment without departing from the scope of the appended claims. The terms of a singular form may include plural forms unless referred to the contrary.

Also, "under", "below", "above', "upper", and the like are used for explaining relation association of components illustrated in the drawings. The terms may be a relative concept and described based on directions expressed in the drawings.

The meaning of "include" or "comprise" specifies a property, a fixed number, a step, an operation, an element, a component or a combination thereof, but does not exclude other properties, fixed numbers, steps, operations, elements, components or combinations thereof.

In this specification, "being directly disposed" (or disposed directly) may mean that there is no layer, film, area, plate, or the like between a portion of the layer, the film, the area, the plate, or the like and the other portion. For example, "directly disposed" may mean being disposed without using an additional member such and an adhesion member between two layers or two members.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term "about" can mean within one or more standard deviations, or within ± 30%, 20%, 10%, 5% of the stated value, for example.

Unless otherwise defined, all terms (including technical and scientific terms) used herein have the same meaning as commonly understood by a person of ordinary skill in the art to which the inventive concept belongs. In addition, terms such as terms defined in commonly used dictionaries should be interpreted as having a meaning consistent with the meaning in the context of the related technology, and unless explicitly defined here, they are interpreted as too ideal or too formal sense.

Hereinafter, a display device in an embodiment of the inventive concept will be described with reference to the accompanying drawings.

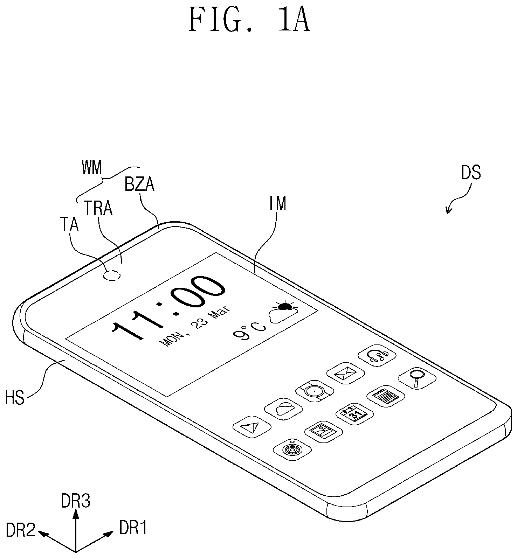

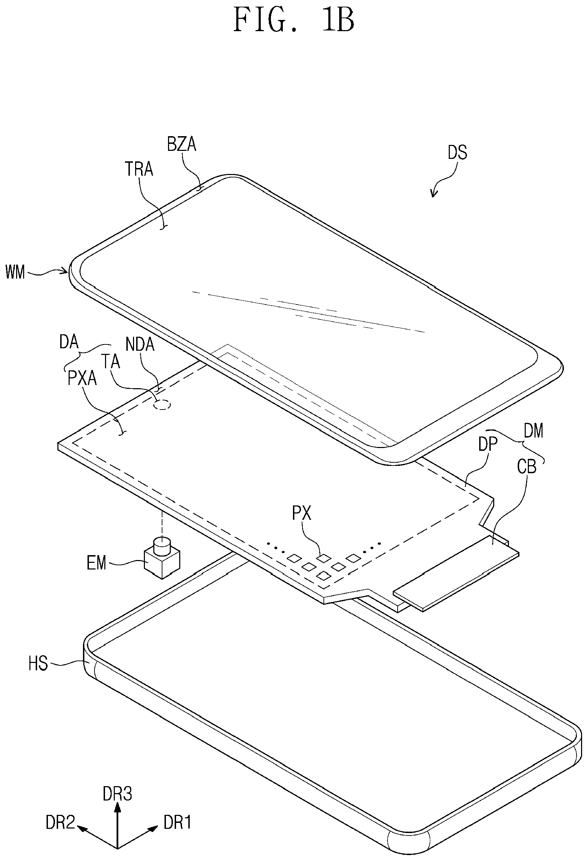

FIG. 1A is a coupling perspective view of an embodiment of a display device according to the inventive concept. FIG. 1B is an exploded perspective view of the display device according to the inventive concept. Hereinafter, an embodiment of the inventive concept will be described with reference to FIGS. 1A and 1B.

A display device DS may be a device that displays an image IM. In an embodiment, the display device DS may include a tablet, a notebook, a computer, a smart phone, television, and the like, for example. In this embodiment, the display device DS including the smart phone will be described as an example.

A user may receive information through the image IM displayed on the display device DS. The image IM may include at least one of a static image or a moving image. In FIG. 1, a watch and a plurality of icons are illustrated in an embodiment of the image IM.

The display device DS may include a window WM, a display module DM, an electronic module EM, and a housing unit HS. The window WM is coupled to the housing unit HS to define an outer appearance of the display device DS.

The window WM may include an optically transparent insulating material. In an embodiment, the window WM may include glass or plastic, for example. The window WM may have a single layer or multilayered structure. In an embodiment, the window WM may have a laminated structure of a plurality of plastic films bonded to each other by an adhesive or a laminated structure of a glass substrate and a plastic film, which are bonded to each other by an adhesive, for example.

The window WM includes a transparent area TRA and a bezel area BZA. The transparent area TRA may be an optically transparent area. The image IM generated by the display module DM may be visually recognized from the outside of the display device DS through the transparent area TRA.

The transparent area TRA may have a shape corresponding to that of a display area DA that will be described later. The transparent area TRA may have a square shape that is parallel to a first direction DR1 and a second direction DR2. However, this is merely an example. In an embodiment, the transparent area TRA may have various shapes and is not limited to any particular embodiment. The second direction DR2 may be perpendicular to the first direction DR1.

The bezel area BZA is adjacent to the transparent area TRA. The bezel area BZA may be an area having a light transmittance that is relatively less than that of the transparent area TRA. When the window WM is provided as a glass or plastic substrate, the bezel area BZA may be a color layer that is printed or formed on one surface of the glass or plastic substrate. In an alternative embodiment, the bezel area BZA may be formed by coloring a corresponding area of the glass or plastic substrate.

The bezel area BZA defines a shape of the transmission area TA. The bezel area BZA may be disposed adjacent to the transparent area TRA to surround the transparent area TRA. However, this is merely an example. In an embodiment, the bezel area BZA may be disposed adjacent to only one side of the transparent area TRA or be omitted, for example.

A direction DR3 (hereinafter, referred to as a third direction) perpendicular to the transparent area TRA may correspond to a thickness direction of the display device DS. The image IM is displayed in the third direction DR3. In this embodiment, a front surface (or a top surface) or a rear surface (or a bottom surface) of each of members may be defined based on a direction in which the image IM is displayed. The front and rear surfaces may be opposite to each other in the third direction DR3. The third direction DR3 may be perpendicular to both the first and second directions DR1 and DR2.

The directions indicated as the first to third direction DR1, DR2, and DR3 may be a relative concept and thus changed into different directions. Hereinafter, the first to third directions may be directions indicated by the first to third directions DR1, DR2, and DR3 and designated by the same reference numerals, respectively.

The display module DM is disposed between the window WM and the housing unit HS. The display module DM may be accommodated in a space provided by coupling the window WM to the housing unit HS. The display module DM may include a display panel DP and a circuit board CB.

The front surface of the display panel DP includes a display area DA and a non-display area NDA. The display area DA may be an area on which a plurality of pixels PX is disposed. The pixels PX generate the image IM.

The display area DA includes an emission area PXA and a transmission area TA. The emission area PXA may be an area on which a plurality of light emitting pixels of the pixels PX is disposed, and the image IM may be displayed through light generated by the light emitting pixels. This will be described later in detail.

The transmission area TA may be an area having light transmittance that is relatively greater than that of the emission area PXA. The transmission area TA may be an area on which a transmission pixel of the pixels PX is disposed. In addition, the relatively small number of light emitting pixels may be disposed on the transmission area TA compared to the emission area PXA. In an embodiment, density of the light emitting pixels disposed on the transmission area TA may be less than that of the light emitting pixels disposed on the emission area PXA, for example. In an alternative embodiment, the light emitting pixels may not be disposed on the transmission area TA.

The transmission area TA is defined adjacent to the emission area PXA. In this embodiment, the entire transmission area TA is defined as being surrounded by the emission area PXA. However, this is merely an example. In an embodiment, the transmission TA may be defined at a position that is partially adjacent to the emission area EA or may be provided in various shapes in addition to a circle shape, for example, but is not limited to any particular embodiment.

The non-display area NDA is adjacent to the display area DA. The non-display area NDA may be an area on which the pixels PX are not disposed. Driving circuits for driving the pixels PX may be disposed on the non-display area NDA.

The circuit board CB is connected to the display panel DP. The circuit board CB is illustrated as being coupled to the display panel DP on the non-display area NDA. The circuit board CB is electrically connected to the display panel DP. Various electronic elements for driving the pixels PX may be disposed (e.g., mounted) on the circuit board CB. This is merely an example. In an embodiment, various electronic elements for driving the pixels PX may be disposed (e.g., mounted) on the display panel DP, for example. Here, the circuit board CB may be omitted. The display device DS in an embodiment of the inventive concept may be implemented according to various embodiments, but is not limited to any particular embodiment.

The electronic module EM is disposed between the window WM and the housing unit HS. The electronic module EM may be accommodated in a space provided by coupling the window WM to the housing unit HS. The electronic module EM is disposed to overlap the display panel DP on the plane.

The electronic module EM overlaps the display area DA of the display panel DP on the plane and overlaps the transparent area TRA of the window WM on the plane. The electronic module EM is disposed to overlap the transmission area TA of the display area DA.

The electronic module EM may include a photographing module such as a camera, a light receiving module such as an infrared sensor, an acoustic module such as a speaker, and a module such as an ultrasonic sensor. In this embodiment, the electronic module EM may photograph a subject existing outside the display device DS through the transmission area TA or may receive an external input provided to the transparent area TRA, e.g., touch or light. Since the electronic module EM is disposed to overlap the display panel DP, the bezel area BZA may be prevented from increasing, and a narrow bezel display device or a borderless display device may be provided. This is merely an example, and the electronic module EM may be disposed to overlap the non-display area NDA or so as not to overlap the display panel DP, but is not limited to an embodiment.

In addition, in an embodiment of the inventive concept, although the display device DS is illustrated as a flat rigid device, the display device DS may be a foldable device. Here, the display device DS may be folded or unfolded around a folding axis overlapping at least a portion of the display area DA, and the display panel DP may be provided flexibly. The display device DS in an embodiment of the inventive concept may be provided in various embodiments as long as the display device DS displays an image, but is not limited to any particular embodiment.

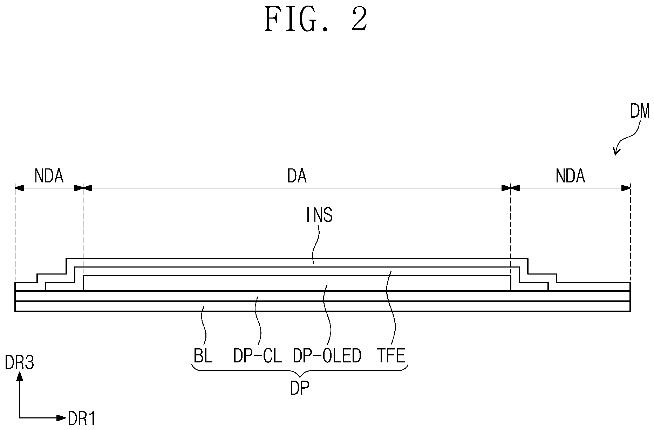

FIG. 2 is a cross-sectional view of an embodiment of a display module according to the invention.

Referring to FIG. 2, the display module DM may include a display panel DP and an input sensor INS. Although not separately shown, the display device DS (refer to FIG. 1A) in an embodiment of the inventive concept may further include an antireflection member and/or a window member disposed on a top surface of a protection member or the input sensor INS disposed on a bottom surface of the display panel DP.

The display panel DP may be an emission type display panel. However, this is merely an example, and the embodiment of the inventive concept is not limited thereto. In an embodiment, the display panel DP may be an organic light emitting display panel or an inorganic light emitting panel, for example. A light emitting layer within the organic light emitting display panel may include an organic light emitting material. A light emitting layer within the inorganic light emitting display panel may include quantum dots, quantum rods, or micro light-emitting diodes (LEDs). Hereinafter, the display panel DP may be described as the organic light emitting display panel.

The display panel DP includes a base layer BL, a circuit element layer DP-CL disposed on the base layer BL, a display element layer DP-OLED, and a thin film encapsulation layer TFE. The input sensor INS may be directly disposed on the thin film encapsulation layer TFE. In this specification, that "a constituent A is directly disposed on a constituent B" may mean that an adhesive layer is not disposed between the constituents A and B.

The base layer BL may include at least one plastic film. The base layer BL may include a plastic substrate, a glass substrate, a metal substrate, or an organic/inorganic composite substrate as a flexible substrate. The display area DA and the non-display area NDA described with reference to FIG. 1B may be equally defined on the base layer BL.

The circuit element layer DP-CL may include at least one insulating layer and circuit element. The insulating layer includes at least one inorganic layer and at least one organic layer. The circuit element includes signal lines, a driving circuit of the pixel, and the like.

The display element layer DP-OLED may include a partition wall and a light emitting element. The light emitting element may include an anode, an intermediate layer, and a cathode.

The thin film encapsulation layer TFE may include a plurality of thin films. Some of the thin films may be disposed to improve optical efficiency, and others of the thin films may be disposed to protect the organic light emitting diodes.

The input sensor INS acquires coordinate information of an external input. The input sensor INS may have a multilayer structure. The input sensor INS may include a single layer or multi-layered conductive layer. In addition, the input sensor INS may include a single layer or multi-layered insulating layer. The input sensor INS may sense an external input in a capacitive manner. However, this is merely an example, and the embodiment of the inventive concept is not limited thereto. In an embodiment, in an embodiment, the input sensor INS may sense an external input in an electromagnetic induction manner or a pressure sensing manner, for example. In another embodiment of the inventive concept, the input sensor INS may be omitted.

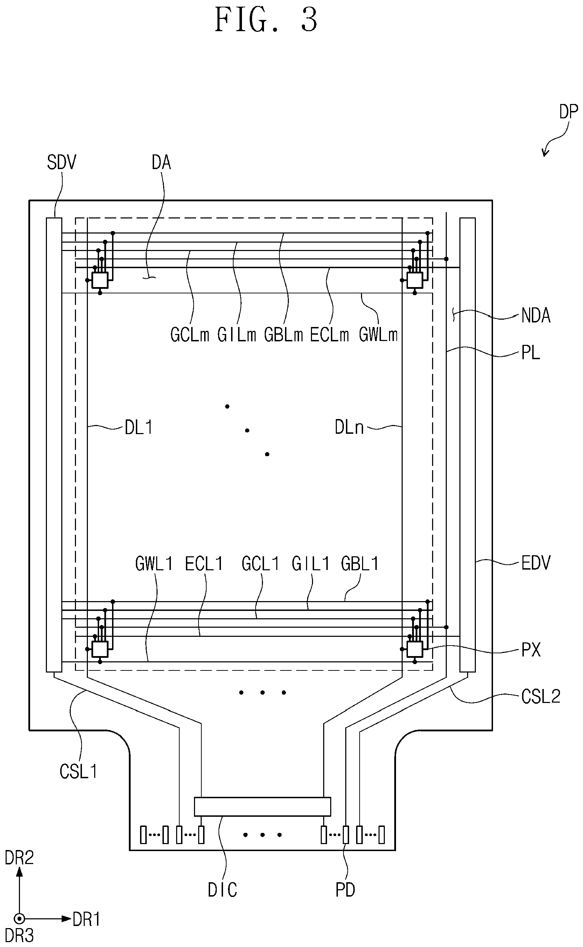

FIG. 3 is a plan view of an embodiment of the display panel according to the inventive concept.

Referring to FIG. 3, a display area DA and a non-display area NDA around the display area DA may be defined on the display panel DP. The display area DA and the non-display area NDA may be distinguished according to whether the pixel PX is disposed. The pixel PX may be disposed on the display area DA. A scan driver SDV, a data driver, and an emission driver EDV may be disposed on the non-display area NDA. The data driver may be a partial circuit configured in a driving chip DIC.

The display panel DP may include pixels PX, initialization scan lines GIL1 to GILm, compensation scan lines GCL1 to GCLm, write scan lines GWL1-GWLm, black scan lines GBL1 to GBLm, emission control lines ECL1 to ECLm, data lines DL1 to DLn, first and second control lines CSL1 and CSL2, a driving voltage line PL, and a plurality of pads PD. Here, m and n are natural numbers greater than or equal to 2.

The pixels PX may be connected to the initialization scan lines GIL1 to GILm, the compensation scan lines GCL1 to GCLm, the write scan lines GWL1 to GWLm, the black scan lines GBL1 to GBLm, the emission control lines ECL1 to ECLm, and the data lines DL1 to DLn.

The initialization scan lines GIL1 to GILm, the compensation scan lines GCL1 to GCLm, the write scan lines GWL1 to GWLm, and the black scan lines GBL1 to GBLm may extend in the first direction DR1 and then be electrically connected to the scan driver SDV. The data lines DL1 to DLn may extend in the second direction DR2 and then may be electrically connected to the driving chip DIC. The emission control lines ECL1 to ECLm may extend in the first direction DR1 and then be electrically connected to the emission driver EDV.

A driving voltage line PL may include a portion extending in the first direction DR1 and a portion extending in the second direction DR2. The portion extending in the first direction DR1 and the portion extending in the second direction DR2 may be disposed in different layers. The driving voltage line PL may provide a driving voltage to the pixels PX.

The first control line CSL1 may be connected to the scan driver SDV. The second control line CSL2 may be connected to the emission driver EDV.

The driving chip DIC, the driving voltage line PL, the first control line CSL1, and the second control line CSL2 may be electrically connected to the pads PD. A circuit board CB (refer to FIG. 1B) may be electrically connected to the pads PD through an anisotropic conductive adhesive layer. The pads PD may be pads for connecting the circuit board CB (refer to FIG. 1B) to the display panel DP. The pads PD may be connected to corresponding pixels PX through the driving voltage line PL, the first control line CSL1, and the second control line CSL2.

In addition, the pads PD may further include input pads. The input pads may be pads for connecting the circuit board CB (refer to FIG. 1B) to the input sensor INS (refer to FIG. 2). However, the embodiment of the inventive concept is not limited thereto, and the input pads may be disposed on the input sensor INS and connected to the pads PD and a separate circuit board. In an alternative embodiment, the input sensor INS may be omitted and may not further include input pads.

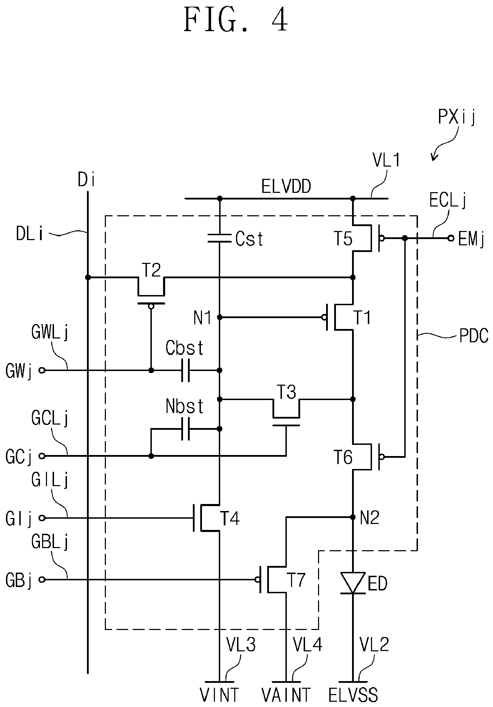

FIG. 4 is an equivalent circuit diagram of an embodiment of the pixel according to the inventive concept.

FIG. 4 is an equivalent circuit diagram illustrating an embodiment of one pixel PXij of the plurality of pixels PX (refer to FIG. 3). Since the plurality of pixels PX has the same circuit structure, detailed descriptions of other pixels PX will be omitted because of being substituting for the descriptions of the circuit structure of the pixel PXij.

Referring to FIGS. 3 and 4, the pixel PXij may be connected to an i-th data line DLi of the data lines DL1 to DLn, a j-th initialization scan line GILj of the initialization scan lines GIL1 to GILm, a j-th compensation scan line GCLj of the compensation scan lines GCL1 to GCLm, a j-th write scan line GWLj of the write scan lines GWL1 to GWLm, a j-th black scan line GBLj of the black scan lines GBL1 to GBLm, a j-th emission control line ECLj of the emission control lines ECL1 to ECLm, first and second driving voltage lines VL1 and VL2, and first and second initialization voltage lines VL3 and VL4. Here, i is an integer greater than or equal to 1 and less than or equal to n, and j is an integer greater than or equal to 1 and less than or equal to m.

The pixel PXij includes a light emitting element ED and a pixel circuit PDC. The light emitting element ED may be an organic light emitting diode. In an embodiment of the inventive concept, the light emitting element ED may be an organic light emitting diode including an organic light emitting layer, but is not particularly limited thereto. The pixel circuit PDC may control an amount of current flowing in the light emitting element ED in response to a data signal Di. The light emitting element ED may emit light having predetermined luminance corresponding to an amount of current supplied from the pixel circuit PDC.

The pixel circuit PDC may include first to seventh transistors T1, T2, T3, T4, T5, T6, and T7, and first to third capacitors Cst, Cbst, and Nbst. According to the inventive concept, a configuration of the pixel circuit PDC is not limited to the embodiment illustrated in FIG. 4. The pixel circuit PDC illustrated in FIG. 4 is merely an example, and the configuration of the pixel circuit PDC may be modified to be implemented.

At least one of the first to seventh transistors T1, T2, T3, T4, T5, T6, and T7 may be a transistor having a low-temperature polycrystalline silicon ("LTPS") semiconductor layer. At least one of the first to seventh transistors T1, T2, T3, T4, T5, T6, and T7 may be a transistor having an oxide semiconductor layer. In an embodiment, the third and fourth transistors T3 and T4 may be oxide semiconductor transistors, and the first, second, fifth, sixth, and seventh transistors T1, T2, T5, T6, and T7 may be LTPS transistors, for example.

Particularly, the first transistor T1, which directly affects brightness of the light emitting element ED, may include a highly reliable polycrystalline silicon semiconductor layer, through which a high-resolution display device is capable of being implemented. Since the oxide semiconductor has relatively high carrier mobility and relatively low leakage current, even when a driving time is long, voltage drop is not large. That is, since a color change of an image due to the voltage drop is not relatively large even during low-frequency driving, low-frequency driving is possible. As described above, in the case of the oxide semiconductor, since the leakage current is small, at least one of the third transistor T3 or the fourth transistor T4 connected to the gate electrode of the first transistor T1 may be employed as the oxide semiconductor to prevent the leakage current flowing to the gate electrode and also reduce power consumption.

Some of the first to seventh transistors T1, T2, T3, T4, T5, T6, and T7 may be P-type transistors, and others may be N-type transistors. In an embodiment, the first, second, fifth, sixth, and seventh transistors T1, T2, T5, T6, and T7 are P-type transistors, and the third and fourth transistors T3 and T4 may be N-type transistors, for example.

The configuration of the pixel circuit PDC according to the inventive concept is not limited to the embodiment illustrated in FIG. 4. The pixel circuit PDC illustrated in FIG. 4 is merely an example, and the configuration of the pixel circuit PDC may be modified to be implemented. In an embodiment, all of the first to seventh transistors T1, T2, T3, T4, T5, T6, and T7 may be P-type transistors or N-type transistors, for example. In an alternative embodiment, the first, second, fifth, and sixth transistors T1, T2, T5, and T6 may be P-type transistors, and the third, fourth, and seventh transistors T3, T4, and T7 may also be N-type transistors.

The j-th initialization scan line GILj, the j-th compensation scan line GCLj, the j-th write scan line GWLj, the j-th black scan line GBLj, and the j-th emission control line ECLj may transmit the j-th initialization scan signal GIj, the j-th compensation scan signal GCj, the j-th write scan signal GWj, the j-th black scan signal GBj, and the j-th emission control signal EMj to the pixel PXij, respectively. The i-th data line DLi may transmit an i-th data signal Di to the pixel PXij. The i-th data signal Di may have a voltage level corresponding to an image signal inputted to the display device DS (refer to FIG. 1A).

The first and second driving voltage lines VL1 and VL2 may transmit a first driving voltage ELVDD and a second driving voltage ELVSS to the pixel PXij, respectively. In addition, the first and second initialization voltage lines VL3 and VL4 may transmit first and second initialization voltages VINT and VAINT to the pixel PXij, respectively.

The first transistor T1 may be connected between the first driving voltage line VL1 receiving the first driving voltage ELVDD and the light emitting element ED. The first transistor T1 includes a first electrode connected to the first driving voltage line VL1 via the fifth transistor T5, a second electrode connected to the pixel electrode (or referred to as an anode) of the light emitting element ED via the sixth transistor T6, and a third electrode (e.g., gate electrode) connected to one end (e.g., first node N1) of the first capacitor Cst. The first transistor T1 may receive the i-th data signal Di transmitted from the i-th data line DLi according to a switching operation of the second transistor T2 to supply driving current to the light emitting diode ED.

The second transistor T2 is connected between the data lien DLi and the first electrode of the first transistor T1. The second transistor T2 includes a first electrode connected to the data line DLi, a second electrode connected to the first electrode of the first transistor T1, and a third electrode (e.g., gate electrode) connected to a j-th write scan line GWLj. The second transistor T2 may be turned on according to the write scan signal GWj transmitted through the j-th write scan line GWLj to transmit the i-th data signal Di transmitted from the i-th data line DLi to the first electrode of the first transistor T1. One end of the second capacitor Cbst may be connected to the third electrode of the second transistor T2, and the other end of the second capacitor Cbst may be connected to the first node N1.

The third transistor T3 is connected between the second electrode of the first transistor T1 and the first node N1. The third transistor T3 includes a first electrode connected to the third electrode of the first transistor T1, a second electrode connected to the second electrode of the first transistor T1, and a third electrode (e.g., gate electrode) connected to the j-th compensation scan line GCLj. The third transistor T3 may be turned on according to the j-th compensation scan signal GCj transmitted through the j-th compensation scan line GCLj to connect the third electrode of the first transistor T1 to the second electrode of the first transistor T1, thereby diode-connecting the first transistor T1. One end of the third capacitor Nbst may be connected to the third electrode of the third transistor T3, and the other end of the third capacitor Nbst may be connected to the first node N1.

The fourth transistor T4 is connected between the first initialization voltage line VL3, to which the first initialization voltage VINT is applied, and the first node N1. The fourth transistor T4 includes a first electrode connected to the first initialization voltage line VL3, to which the first initialization voltage VINT is transmitted, a second electrode connected to the first node N1, and a third electrode (e.g., gate electrode) connected to the j-th initialization scan line GILj. The fourth transistor T4 is turned on according to the j-th initialization scan signal GIj transmitted through the j-th initialization scan line GILj. The turn-on fourth transistor T4 transmits the first initialization voltage VINT to the first node N1 to initialize a potential of the third electrode (i.e., potential of the first node N1) of the first transistor T1.

The fifth transistor T5 includes a first electrode connected to the first driving voltage line VL1, a second electrode connected to the first electrode of the first transistor T1, and a third electrode (e.g., gate electrode) connected to the j-th emission control line ECLj. The sixth transistor T6 includes a first electrode connected to the second electrode of the first transistor T1, a second electrode connected to the pixel electrode of the light emitting element ED, and a third electrode (e.g., gate electrode) connected to the j-th emission control line ECLj.

The fifth and sixth transistors T5 and T6 are simultaneously turned on according to the j-th emission control signal EMj transmitted through the j-th emission control line ECLj. The first driving voltage ELVDD applied through the turn-on fifth transistor T5 may be compensated through the diode-connected first transistor T1 and then be transferred to the light emitting element ED through the sixth transistor T6.

The seventh transistor T7 includes a first electrode connected to the second initialization voltage line VL4, to which the second initialization voltage VAINT is transmitted, a second electrode connected to a second node N2 connected to the second electrode of the sixth transistor T6 and the light emitting element ED, and a third electrode (e.g., gate electrode) connected to the black scan line GBLj. The second initialization voltage VAINT may have a voltage level equal to or less than that of the first initialization voltage VINT.

One end of the first capacitor Cst may be connected to the third electrode of the first transistor T1, and the other end of the first capacitor Cst may be connected to the first driving voltage line VL1. The cathode of the light emitting element ED may be connected to the second driving voltage line VL2 that transmits the second driving voltage ELVSS. The second driving voltage ELVSS may have a voltage level less than that of the first driving voltage ELVDD.

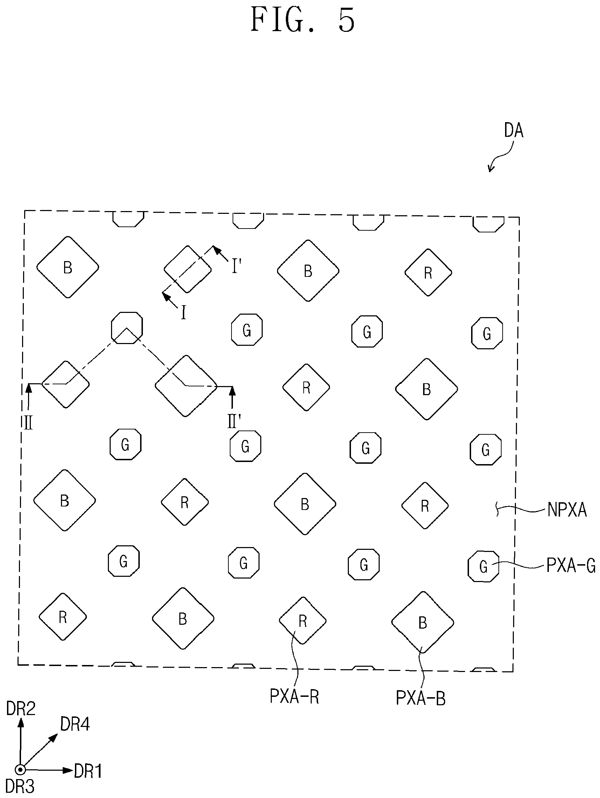

FIG. 5 is an enlarged plan view illustrating an embodiment of a portion of a display area of the display panel according to the inventive concept. FIG. 5 is a plan view illustrating the display module DM when viewed on the display of the display module DM (refer to FIG. 1B) and illustrates an arrangement of the emission areas PXA-R, PXA-G, and PXA-B.

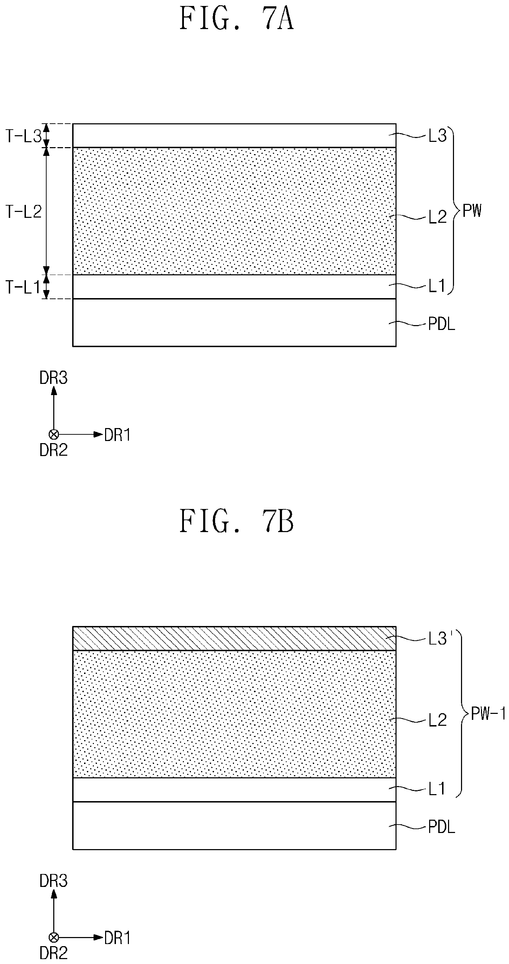

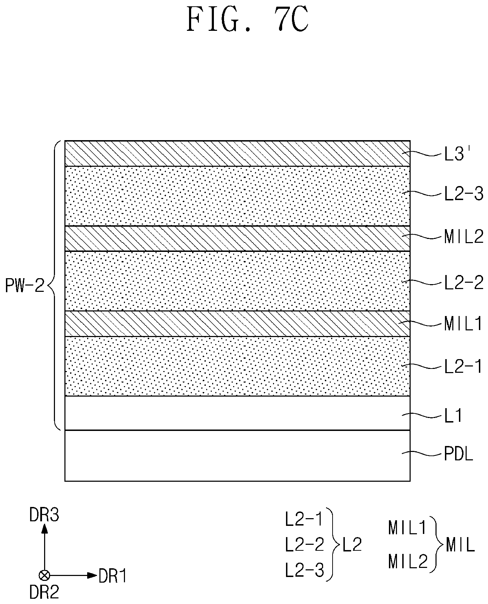

Referring to FIG. 5, the display area DA may include first to third emission areas PXA-R, PXA-G and PXA-B and a peripheral area NPXA surrounding the first to third emission areas PXA-R and PXA-G, and PXA-B. The first to third emission areas PXA-R, PXA-G, and PXA-B may correspond to areas from which light provided from the light emitting elements ED1, ED2, and ED3 (refer to FIG. 7) is emitted, respectively. The first to third emission areas PXA-R, PXA-G, and PXA-B may be classified according to a color of light emitted toward the outside of the display module DM (refer to FIG. 2).

The first to third emission areas PXA-R, PXA-G, and PXA-B may provide first to third color light having different colors, respectively. In an embodiment, the first color light may be red light, the second color light may be green light, and the third color light may be blue light, for example. However, embodiments of the first to third color light are not necessarily limited to the above example.

Each of the first to third emission areas PXA-R, PXA-G, and PXA-B may be defined as an area on which a top surface of the anode is exposed by a light emitting opening to be described later. The peripheral area NPXA may set a boundary between the first to third emission areas PXA-R, PXA-G, and PXA-B to prevent colors from being mixed with each other between the first to third emission areas PXA-R, PXA-G, and PXA-B.

Each of the first to third emission areas PXA-R, PXA-G, and PXA-B may be provided in plurality and repeatedly disposed in a predetermined arrangement form within the display area DA. In an embodiment, the first and third emission areas PXA-R and PXA-B may be alternately arranged in the first direction DR1 to constitute a 'first group', for example. The second emission areas PXA-G may be arranged in the first direction DR1 to constitute a 'second group'. Each of the 'first group' and the 'second group' may be provided in plurality, and the 'first groups' and the 'second groups' may be alternately arranged in the second direction DR2.

One second emission area PXA-G may be spaced apart from one first emission area PXA-R or one third emission area PXA-B in the fourth direction DR4. The fourth direction DR4 may be a direction between the first direction DR1 and the second direction DR2. The fourth direction DR4 may be at an angle between the first and second directions DR1 and DR2.

FIG. 5 illustrates an arrangement of the first to third emission areas PXA-R, PXA-G, and PXA-B in an embodiment, but is not limited thereto and may be arranged in various forms. In an embodiment, the first to third emission areas PXA-R, PXA-G, and PXA-B may have a PENTILE^{™} arrangement as illustrated in FIG. 5. In an alternative embodiment, the first to third emission areas PXA-R, PXA-G, and PXA-B may have a stripe arrangement or a DIAMOND PIXEL^{™} arrangement, for example.

The first to third emission areas PXA-B, PXA-G, and PXA-B may have various shapes on the plane. In an embodiment, each of the first to third emission areas PXA-R, PXA-G, and PXA-B may have a polygonal, circular, or elliptical shape, for example. FIG. 5 illustrates first and third emission areas PXA-R and PXA-B, each of which has a quadrangular shape (or diamond shape), and a second emission area PXA-G having an octagonal shape on the plane as an example.

The first to third emission areas PXA-R, PXA-G, and PXA-B may have the same shape on the plane, or at least a portion of the first to third emission areas PXA-R, PXA-G, and PXA-B may have a different shape. FIG. 5 illustrates first and third emission areas PXA-R and PXA-B having the same shape on the plane and the second emission area PXA-G having a shape different from that of each of the first and third emission areas PXA-R and PXA-B as an example.

At least a portion of the first to third emission areas PXA-R, PXA-G, and PXA-B may have a different area on the plane. In an embodiment, a surface area of the first emission area PXA-R emitting the red light may be greater than that of the second emission area PXA-G emitting the green light, and a surface area of the third emission area emitting the blue light may be less than that of the third emission area PXA-B. However, a size relationship in area between the first to third emission areas PXA-R, PXA-G, and PXA-B according to the emission color is not limited thereto and may vary according to a design of the display module DM (refer to FIG. 2). In addition, the embodiment of the inventive concept is not limited thereto, and the first to third emission areas PXA-R, PXA-G, and PXA-B may have the same area on the plane.

In the display device DS (refer to FIG. 1) of the inventive concept, the shape, the surface area, the arrangement, etc., of the first to third emission areas PXA-R, PXA-G, and PXA-B may be variously designed according to the colors of the emitted light or the size and configuration of the display module DM (refer to FIG. 1), but are not limited to the embodiment illustrated in FIG. 3.

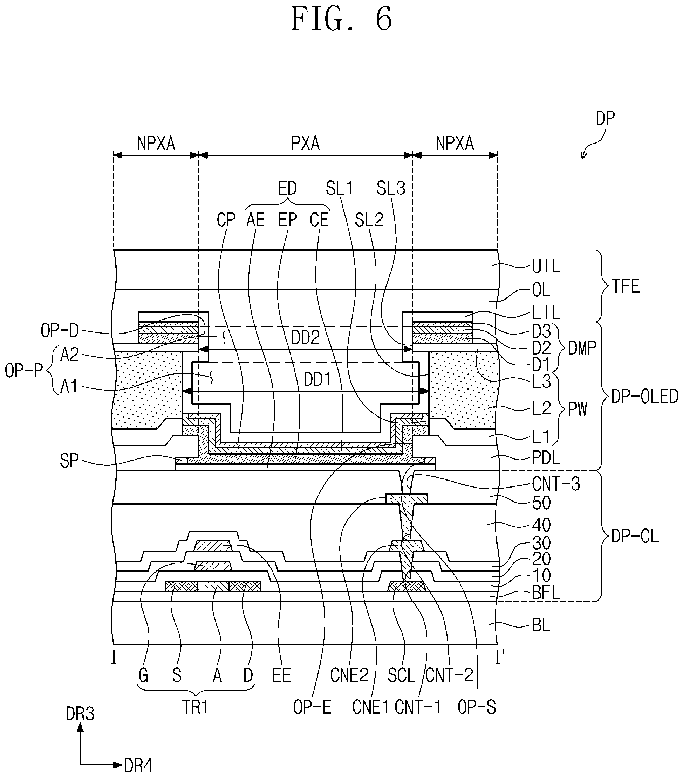

FIG. 6 is a cross-sectional view of an embodiment of the display panel according to the inventive concept. FIG. 6 is a cross-sectional view taken along line I-I' of FIG. 5. In the description of FIG. 6, it will be described with reference to FIG. 2, and descriptions of the configurations having the same reference numerals will be omitted.

FIG. 6 is an enlarged view of one emission area PXA within the display area DA (refer to FIG. 5 ), and the emission area PXA of FIG. 6 may correspond to one of the first to third emission areas PXA-R, PXA-G, and PXA-B of FIG. 5.

Referring to FIG. 6, the display panel DP may include a base layer BL, a circuit element layer DP-CL, a display element layer DP-OLED, and a thin film encapsulation layer TFE.

The display panel DP may include a plurality of insulating layers, a semiconductor pattern, a conductive pattern, a signal line, and the like. The insulating layer, the semiconductor layer, and the conductive layer may be formed in a manner such as coating, deposition, or the like. Thereafter, the insulating layer, the semiconductor layer, and the conductive layer may be selectively patterned through photolithography and etching processes. The semiconductor pattern, the conductive pattern, and the signal line, which are provided in the circuit element layer DP-CL and the display element layer DP-OLED, may be formed in the above-described manner.

The circuit element layer DP-CL may be disposed on the base layer BL. The circuit element layer DP-CL may include a buffer layer BFL, a transistor TR1, a signal transmission area SCL, first to fifth insulating layers 10, 20, 30, 40, and 50, an upper electrode EE, and a plurality of connection electrodes CNE1 and CNE2.

The buffer layer BFL may be disposed on the base layer BL. The buffer layer BFL may improve bonding force between the base layer BL and the semiconductor pattern. The buffer layer BFL may include a silicon oxide layer and a silicon nitride layer. The silicon oxide layer and the silicon nitride layer may be alternately laminated.

A semiconductor pattern may be disposed on the buffer layer BFL. The semiconductor pattern may include polysilicon. However, the disclosure is not limited thereto. In an embodiment, the semiconductor pattern may include amorphous silicon or metal oxide. In FIG. 6, a portion of the semiconductor pattern is illustrated in an embodiment, and semiconductor patterns may be further disposed on the plurality of emission areas PXA-R, PXA-G, and PXA-B (refer to FIG. 5), for example. The semiconductor pattern may be arranged in a specific rule over the plurality of emission areas PXA-R, PXA-G, and PXA-B. The semiconductor pattern has different electrical properties depending on whether the semiconductor pattern is doped. The semiconductor pattern may include a first region having a relatively high doping concentration and a second region having a relatively low doping concentration. The first region may be doped with an N-type dopant or a P-type dopant. A P-type transistor may include the first region doped with the P-type dopant.

The first area may have conductivity greater than that of the second area and may substantially serve as an electrode or a signal line. The second region may substantially correspond to an active (or channel) of the transistor. That is to say, a portion of the semiconductor pattern may be an active of the transistor, another portion may be a drain of the transistor, and further another portion may be a conductive area.

A source S, an active A, and a drain D of the transistor TR1 may be formed from the semiconductor pattern. FIG 6 illustrates a portion of a signal transmission area SCL formed from the semiconductor pattern. Although not particularly shown, the signal transmission area SCL may be connected to the drain D1 of the transistor TR1 on the plane.

The first to fifth insulating layers 10, 20, 30, 40, and 50 may be disposed on the buffer layer BFL. Each of the first to fifth insulating layers 10, 20, 30, 40, and 50 may be an organic layer or an inorganic layer.

A first insulating layer 10 may be disposed on the buffer layer BFL. The first insulating layer 10 may cover the source S, the active A, the drain D, and the signal transmission area SCL of the transistor TR1 disposed on the buffer layer BFL. The gate G of the transistor TR1 may be disposed on the first insulating layer 10. The second insulating layer 20 may be disposed on the first insulating layer 10 to cover the gate G. An upper electrode EE may be disposed on the second insulating layer 20. The third insulation layer 30 may be disposed on the second insulation layer 20 to cover the upper electrode EE.

A first connection electrode CNE1 may be disposed on the third insulating layer 30. The first connection electrode CNE1 may be connected to the signal transmission area SCL through a contact hole CNT-1 passing through the first to third insulating layers 10 to 30. A fourth insulating layer 40 may be disposed on the third insulating layer 30 to cover the first connection electrode CNE1. The fourth insulating layer 40 may be an organic layer.

A second connection electrode CNE2 may be disposed on the fourth insulating layer 40. The second connection electrode CNE2 may be connected to the first connection electrode CNE1 through a contact hole CNT-2 passing through the fourth insulating layer 40. A fifth insulating layer 50 may be disposed on the fourth insulating layer 40 to cover the second connection electrode CNE2. The fifth insulating layer 50 may be an organic layer.

The display element layer DP-OLED may be disposed on the circuit element layer DP-CL. The display element layer DP-OLED may include a light emitting element ED, a sacrificial pattern SP, a pixel defining layer PDL, a partition wall PW, and dummy patterns DMP.

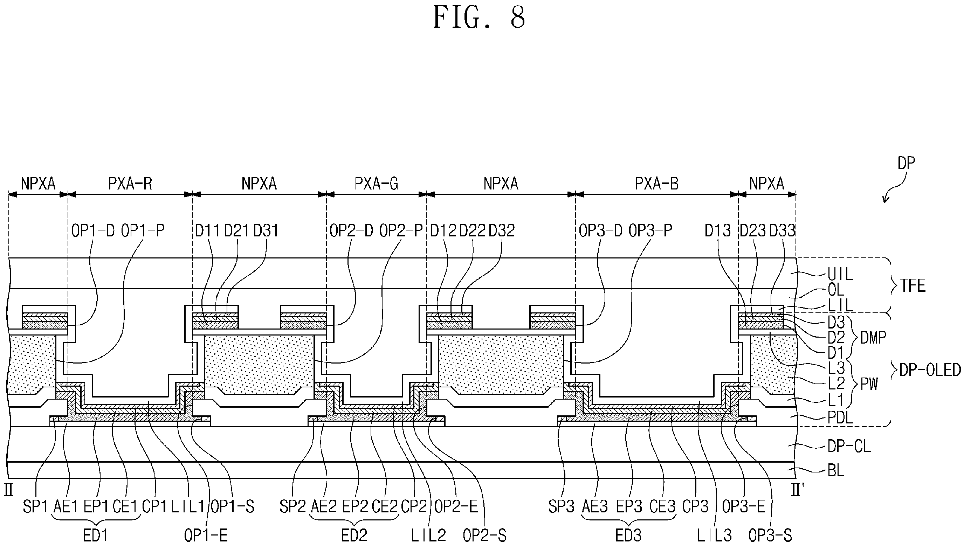

The light emitting element ED may include an anode AE (or first electrode), a light emitting pattern EP, and a cathode CE (or second electrode). Each of the first to third light emitting elements ED1, ED2, and ED3 (refer to FIG. 8) to be described below may have substantially the same configuration as the light emitting element ED of FIG. 6. The descriptions of the anode AE, the light emitting pattern EP, and the cathode CE may be equally applied to all of the anode, the light emitting pattern, and the cathode of each of the first to third light emitting elements to be described later.

The anode AE may be disposed on the fifth insulating layer 50 of the circuit element layer DP-CL. The anode AE may be a transmissive electrode, a semitransmissive electrode, or a reflective electrode. The anode AE may be connected to the second connection electrode CNE2 through a connection contact hole CNT- 3 defined to pass through the fifth insulating layer 50. Thus, the anode AE may be electrically connected to the signal transfer area SCL through the first and second connection electrodes CNE1 and CNE2 and then electrically connected to corresponding circuit element. The anode AE may have a single-layer or multi-layered structure. The anode AE may include a plurality of layers including or consisting of indium tin oxide ("ITO") and Ag. In an embodiment, the anode AE may include a layer including or consisting of ITO (hereinafter, referred to as lower ITO layer), a layer including or consisting of Ag disposed on the lower ITO layer (hereinafter, referred to as Ag layer), and a layer including or consisting of ITO disposed on the Ag layer (hereinafter, an upper ITO layer), for example.

The sacrificial pattern SP may be disposed between the anode AE and the pixel defining layer PDL. The sacrificial pattern SP may correspond to a portion of a layer provided to prevent the anode AE from being damaged in a process of forming a partition wall opening OP-P, which will be described later. A sacrificial opening OP-S exposing a portion of a top surface of the anode AE may be defined in the sacrificial pattern SP. The sacrificial opening OP-S may overlap a light emitting opening OP-E to be described later. The sacrificial pattern SP may include an amorphous transparent conductive oxide. In an embodiment, the sacrificial pattern SP may be zinc oxide (ZnOx) doped with aluminum (Al), for example.

The pixel defining layer PDL may be disposed on the fifth insulating layer 50 of the circuit element layer DP-CL. The light emitting opening OP-E may be defined in the pixel defining layer PDL. The light emitting opening OP-E may correspond to the anode AE, and the pixel defining layer PDL may expose at least a portion of the anode AE through the light emitting opening OP-E.

In addition, the light emitting opening OP-E may correspond to the sacrificial opening OP-S of the sacrificial pattern SP. According to this embodiment, the top surface of the anode AE may be spaced apart from the pixel defining layer PDL in cross-section with the sacrificial pattern SP therebetween, and thus, in the process of forming the light emitting opening OP-E, the anode AR may be prevented from being damaged.

On the plane, a surface area of the light emitting opening OP-E may be less than that of the sacrificial opening OP-S. That is, an inner surface of the pixel defining layer PDL defining the light emitting opening OP-E may be closer to a center of the anode AE than an inner surface of the sacrificial pattern SP defining the sacrificial opening OP-S is to the center of the anode AE. The plane may be defined by the third direction DR3 and/or the fourth direction DR4. The plane may be the plane defined by the fourth direction DR4. However, the embodiment of the inventive concept is not limited thereto, and the inner surface of the sacrificial pattern SP defining the sacrificial opening OP-S may be substantially aligned with the inner surface of the pixel defining layer PDL defining the corresponding light emitting opening OP-E. Here, the emission area PXA may be regarded as an area of the anode AE exposed through the corresponding sacrificial opening OP-S.

The pixel defining layer PDL may include or consist of an inorganic insulating material. The pixel defining layer PDL may include or consist of at least one of silicon oxide (SiOₓ), silicon nitride (SiNₓ), and silicon oxynitride (SiOₓN_{y}). In an embodiment, the pixel defining layer PDL may include or consist of silicon nitride (SiNₓ), for example. The pixel defining layer PDL may be disposed between the anode AE and the partition wall PW to block electrical connection between the anode AE and the partition wall PW.

The partition wall PW may be disposed on the pixel defining layer PDL. A partition wall opening OP-P may be defined in the partition wall PW. The partition wall opening OP-P may correspond to the light emitting opening OP-E and may expose at least a portion of the anode AE.

The partition wall PW may have an undercut shape in cross-section. The partition wall PW may include a plurality of layers sequentially laminated, and at least one layer of the plurality of layers may be recessed when compared to other layers. At least one of the plurality of layers provided in the partition wall PW may protrude compared to other layers. Thus, the partition wall PW may include a tip part.

The partition wall PW may include a first partition wall layer L1, a second partition wall layer L2, and a third partition wall layer L3. The first partition wall layer L1 and the second partition wall layer L2 may be relatively recessed compared to the third partition wall layer L3, based on the emission area PXA, That is, the first partition wall layer L1 and the second partition wall layer L2 may be provided by undercutting the third partition wall layer L3.

FIG. 6 illustrates the structure in which the first partition wall layer L1 and the second partition wall layer L2 are etched so that the third partition wall layer L3 forms the tip part of the partition wall PW, but the embodiment of the inventive concept is not limited to the shape of the partition wall PW. In an embodiment, only the first partition wall layer L1 may be etched so that each of the second partition wall layer L2 and the third partition wall layer L3 forms a tip part, or a portion of each of the first partition wall layer L1 and the second partition wall layer may be etched so that each of a remaining portion of the second partition wall layer L2 and the third partition wall layer L3 forms a tip part, for example.

The partition wall opening OP-P defined in the partition wall PW may include a first area A1 and a second area A2. The first partition wall layer L1 may include a first inner surface SL1 defining a portion of the first area A1 of the partition wall opening OP-P, and the second partition wall layer L2 may include a second inner surface SL2 defining the other portion of the first area A1. The third partition wall layer L3 may include a third inner surface SL3 defining the second area A2.

The first inner surface SL1 of the first partition wall layer L1 and the second inner surface SL2 of the second partition wall layer L2 may define one alignment surface extending in the third direction DR3. One surface of the first inner surface SL1 and the second inner surface SL2 may protrude or be recessed with respect to the other surface to define side surfaces that are disposed side-by-side, not surfaces on which a stepped portion occurs.

The first inner surface SL1 of the first partition wall layer L1 and the second inner surface SL2 of the second partition wall layer L2 may be recessed relatively inward rather than the third inner surface SL3 of the third partition wall L3. That is, the first inner surface SL1 and the second inner surface SL2 may be formed by undercutting the third inner surface SL3. The third partition wall layer L3 protruding toward the emission area PXA may define a tip part.

A width DD1 of the first area A1 may be different from a width DD2 of the second area A2. The width DD1 of the first area A1 may be greater than the width DD2 of the second area A2. In this case, the second area A2 of the partition wall opening OP-P may be an area defining the tip part.

The third inner surface SL3 of the third partition wall layer L3 defining the second area A2 may protrude further compared to each of the first inner surface SL1 of the first partition wall layer L1, which define the first area A1, and the second inner surface SL2 of the second partition wall layer L2. That is, the third inner surface SL3 may be disposed adjacent to a center of the anode AE in one direction, e.g., in the fourth direction DR4, when compared to each of the first inner surface SL1 and the second inner surface SL2.

FIGS. 7A to 7C are cross-sectional views illustrating an embodiment of a portion of a configuration of the display panel according to the inventive concept. In FIGS. 7A to 7C, the shape of each of the partition walls PW, PW-1, and PW-2 disposed on the pixel defining layer PDL among the components illustrated in FIG. 6 are illustrated to be simplified.

Referring to FIGS. 6 and 7A together, the first partition wall layer L1 provided in the partition wall PW may be disposed on the pixel defining layer PDL. The first partition wall layer L1 may be directly disposed on the pixel defining layer PDL. The first partition wall layer L1 may include or consist of a conductive material. The first partition wall layer L1 may include or consist of a low-resistance metal. The first partition wall layer L1 may include or consist of gold (Au), silver (Ag), aluminum (Al), magnesium (Mg), lithium (Li), molybdenum (Mo), copper (Cu), or an alloy thereof. In an embodiment, the first partition wall layer L1 may contain, e.g., aluminum (Al), for example. A thickness T-L1 of the first partition wall layer L1 may be greater than or equal to about 1,000 angstroms and less than or equal to about 2,500 angstroms.

The second partition wall layer L2 may be disposed on the first partition wall layer L1. The second partition wall layer L2 may be directly disposed on the first partition wall layer L1. The second partition wall layer L2 may be a layer having a thick thickness and relatively high electrical conductivity and may be reduced in contact resistance with the cathode CE and thus may provide a uniform voltage to the cathodes CE respectively disposed on the plurality of emission areas PXA.

The second partition wall layer L2 may include or consist of a conductive inorganic material. In an embodiment, the second partition wall layer L2 may include or consist of at least one of amorphous carbon, polycrystalline silicon, or n-type silicon, for example.

The second partition wall layer L2 may include or consist of amorphous carbon. The second partition wall layer L2 may be an amorphous carbon atom layer including amorphous carbon. The second partition wall layer L2 may include or consist of hydrogenated amorphous carbon (a-C:H). Amorphous carbon may be free and highly reactive carbon that does not have a crystalline structure and may have excellent optical and electrical characteristics because most of the amorphous carbon includes or consists of sp2-bonded carbon.

In an alternative embodiment, the second partition wall layer L2 may include or consist of poly-crystalline silicon. The second partition wall layer L2 may be a single layer including polycrystalline silicon. Polycrystalline silicon may be one of crystalline silicon and may include a plurality of crystal nuclei having various crystal arrangements and orientations during a curing process. Polycrystalline silicon may be formed through a simple manufacturing process with a relatively low manufacturing cost when compared to monocrystalline silicon and may have excellent optical and electrical characteristics. The second partition wall layer L2 may include n-type silicon doped with an n-type semiconductor material.

As the second partition wall layer L2 includes or consists of a conductive inorganic material such as amorphous carbon, polycrystalline silicon, or n-type silicon, the second partition wall layer L2 may have excellent electrical characteristics such as relatively high electrical conductivity, and also, the second partition wall layer L2 may have excellent electrical characteristics such as relatively high electrical conductivity, and the second partition wall L2 may include or consist of a material that is easily dry-etched to secure processability of the process of forming the partition wall opening OP-P. In addition, when the second partition wall layer L2 includes or consists of the conductive inorganic material such as amorphous carbon, polycrystalline silicon, or n-type silicon, the conductive inorganic material may have relatively low reactivity with oxygen so that an oxide film is not formed, and thus, defects such as an increase in contact resistance may be prevented from occurring.

A thickness T-L2 of the second partition wall layer L2 may be greater than or equal to about 4,000 angstroms and less than or equal to about 5,000 angstroms. The thickness T-L2 of the second partition wall layer L2 may be greater than the thickness T-L1 of the first partition wall layer L1.

As illustrated in FIG. 6, the cathode CE may be in contact with each of the first inner surface SL1 of the first partition wall layer L1 and the second inner surface SL2 of the second partition wall layer L2 and may receive the second driving voltage ELVSS (refer to FIG. 3B) from the first partition wall layer L1 and the second partition wall layer L2. As the second partition wall layer L2 includes or consists of the conductive inorganic material, the second partition wall layer L2 may have a relatively high reduction potential, and thus, an oxide film may be formed on the second partition wall layer L2 to reduce or remove a phenomenon in which electrical resistance increases at a portion that is in contact with the second partition wall layer L2 and the cathode CE.

FIG. 6 illustrates an embodiment in which the light emitting pattern EP and the cathode CE are in contact with the first inner surface SL1 of the first partition wall layer L1, and the cathode CE is in contact with the second partition wall layer of the second partition wall layer L2, the embodiment of the inventive concept is not limited thereto. In an embodiment, the cathode CE may not be in contact with either the first inner surface SL1 of the first partition wall layer L1 or the second inner surface SL2 of the second partition wall layer L2, for example. The light emitting pattern EP may not be in contact with the first inner surface SL1 of the first partition wall layer L1.

The third partition wall layer L3 may be disposed on the second partition wall layer L2. The third partition wall layer L3 may be directly disposed on the second partition wall layer L2. The third partition wall layer L3 may define a tip part formed on the partition wall PW. A top surface of the third partition wall layer L3 may define the uppermost surface of the partition wall PW and may define a top surface of the tip part formed on the partition wall PW.

The third partition wall layer L3 may include or consist of a material having electrical conductivity less than that of each of the first partition wall layer L1 and the second partition wall layer L2 and having strength greater than that of each of the first partition wall layer L1 and the second partition wall layer L2. The third partition wall layer L3 may include or consist of a material having a relatively high Young's modulus of about 300 gigapascals (GPa) or more. Since the third partition wall layer L3 includes or consists of the material having the relatively high Young's modulus, a degree of deformation of the third partition wall layer L3 may be reduced. As the degree of deformation of the third partition wall layer L3 constituting the uppermost surface of the tip part decreases, robustness of the undercut shape of the partition wall PW may increase. Thus, the shape in which the tip part of the partition wall PW droops may be reduced or removed, and the shape in which the tip part blocks the inner surface of the partition wall PW that is in contact with the cathode CE may be reduced or removed.

In an embodiment, the third partition wall layer L3 may include or consist of a metal material. The third partition wall layer L3 may include or consist of gold (Au), silver (Ag), aluminum (Al), magnesium (Mg), lithium (Li), molybdenum (Mo), titanium (Ti), copper (Cu), or an alloy thereof.

The third partition wall layer L3 includes or consists of gold (Au), silver (Ag), aluminum (Al), magnesium (Mg), lithium (Li), molybdenum (Mo), copper (Cu), or these may include or consist of an alloy of The third partition wall layer L3 may include or consist of a metal material different from that of the first partition wall layer L1. The third partition wall layer L3 may contain, e.g., titanium (Ti). A thickness T-L3 of the third partition wall layer L3 may be greater than or equal to about 500 angstroms and less than or equal to about 1,000 angstroms.

As illustrated in FIG. 7B, in the partition wall PW-1 in an embodiment, a third partition wall layer L3' may not include or consist of a metal material unlike the first partition wall layer L1. The third partition wall layer L3' may include or consist of a silicon-based compound. The third partition wall layer L3' may include or consist of at least one of silicon oxide (SiOx), silicon nitride (SiNx), or silicon oxynitride (SiOxNy). The third partition wall layer L3' may contain, e.g., silicon oxide (SiOx). Unlike the first partition wall layer L1 and the second partition wall layer L2, the third partition wall layer L3' may not be in contact with the cathode CE and may form a tip part to separate the cathode CE from each of the emission areas PXA and thus may include or consist of a silicon-based compound which is an insulating material.

As illustrated in FIG. 7C, the partition wall PW-2 in an embodiment may include a plurality of second partition wall layers L2. The plurality of second partition wall layers L2 may include a plurality of sub partition wall layers L2-1, L2-2, and L2-3 that are spaced apart from each other in the third direction DR3. FIG. 7C illustrates the structure in which the plurality of second partition wall layers L2 includes three sub partition wall layers L2-1, L2-2, and L2-3 spaced apart from each other in the third direction DR3 in an embodiment, but the embodiment of the inventive concept is not limited thereto. In an embodiment, the plurality of second partition wall layers L2 may include two, four or more sub partition wall layers, for example.

The partition wall PW-2 in an embodiment may include a plurality of second partition wall layers L2, and the plurality of second partition wall layers L2 may include a first sub partition wall layer L2-1, a second sub partition wall layer L2-2, and a third sub partition wall layer L2-3, which are spaced apart from each other in the third direction DR3. Intermediate inorganic layers MIL may be disposed between the first sub partition wall layer L2-1, the second sub partition wall layer L2-2, and the third sub partition wall layer L2-3. That is, the plurality of sub partition wall layers L2-1, L2-2, and L2-3 may be spaced apart from each other in the third direction DR3 with the intermediate inorganic layers MIL therebetween. The intermediate inorganic layers MIL may include a first intermediate inorganic layer MIL1 disposed between the first sub partition wall layer L2-1 and the second sub partition wall layer L2-2, and a second intermediate inorganic layer MIL2 disposed between the second sub partition wall layer L2-2 and the third sub partition wall layer L2-3.

Each of the plurality of sub partition wall layers L2-1, L2-2, and L2-3 may include or consist of a conductive inorganic material. In an embodiment, each of the plurality of sub partition wall layers L2-1, L2-2, and L2-3 may include or consist of at least one of amorphous carbon, polycrystalline silicon, or n-type silicon. Each of the plurality of sub partition wall layers L2-1, L2-2, and L2-3 may include or consist of at least one of hydrogenated amorphous carbon (a-C:H), polycrystalline silicon, or n-type silicon, for example.

Each of the plurality of sub partition wall layers L2-1, L2-2, and L2-3 may include or consist of the same material or different materials. In an embodiment, all of the plurality of sub partition wall layers L2-1, L2-2, and L2-3 may include or consist of hydrogenated amorphous carbon (a-C:H), for example. All of the plurality of sub partition wall layers L2-1, L2-2, and L2-3 may include or consist of hydrogenated amorphous carbon (a-C:H). In an alternative embodiment, all of the plurality of sub partition wall layers L2-1, L2-2, and L2-3 may include or consist of polycrystalline silicon. In an alternative embodiment, a portion of the plurality of sub partition wall layers L2-1, L2-2, and L2-3 may include or consist of hydrogenated amorphous carbon (a-C:H), and others may include or consist of polycrystalline silicon.

Each of the intermediate inorganic layers MIL may include or consist of an inorganic material. In an embodiment, the intermediate inorganic layer MIL may include or consist of a silicon-based compound, for example. The intermediate inorganic layer MIL may include or consist of at least one of silicon oxide (SiOₓ), silicon nitride (SiNₓ), or silicon oxynitride (SiOₓN_{y}). The intermediate inorganic layer MIL may include or consist of silicon oxide (SiOₓ).

The intermediate inorganic layer MIL may include or consist of the same material as that of the third partition wall layer L3'. In an embodiment, both the intermediate inorganic layer MIL and the third partition wall layer L3' may include or consist of silicon oxide, for example. When the plurality of intermediate inorganic layers MIL is provided, each of the plurality of intermediate inorganic layers MIL may include or consist of the same material or different materials. In an embodiment, both the first intermediate inorganic layer MIL1 and the second intermediate inorganic layer MIL2 may include or consist of silicon oxide, for example.

In the partition wall PW-2 in an embodiment, the plurality of sub partition wall layers L2-1, L2-2, and L2-3 including or consisting of inorganic materials and the intermediate inorganic layers MIL1 and MIL2 may be alternately disposed. Thus, a refractive index of each of the plurality of sub partition wall layers L2-1, L2-2, and L2-3 and the intermediate inorganic layers MIL1 and MIL2 may be adjusted to a predetermined range to improve optical characteristics of the display panel including the partition wall PW-2. The partition wall PW-2 in an embodiment may have a structure in which the plurality of sub partition wall layers L2-1, L2-2, and L2-3, each of which includes or consists of a conductive inorganic material such as hydrogenated amorphous carbon (a-C:H) and the intermediate inorganic layers MIL1 and MIL2 each of which includes or consists of a silicon-based inorganic material such as silicon oxide, is alternately disposed, and thus, external light reflectance may be reduced through a structure in which a plurality of inorganic layers having different refractive indexes is alternately disposed. When each of the plurality of sub partition wall layers L2-1, L2-2, and L2-3 includes or consists of hydrogenated amorphous carbon (a-C:H), a refractive index of the hydrogenated amorphous carbon atomic layer may be controlled by adjusting a flow rate of C₂H₄ gas and H₂ gas to form the hydrogenated amorphous carbon atomic layer, and thus, the refractive index of the inorganic layer alternating structure for reducing the external light reflectance may be secured.

Referring again to FIG. 6, FIG. 6 illustrates the structure in which each of the first inner surface SL1, the second inner surface SL2, and the third inner surface SL3 is perpendicular to the top surface of the pixel defining layer PDL to extend in the third direction DR3 in an embodiment, but is not limited thereto. In an embodiment, the partition wall PW may have a tapered shape or a reverse tapered shape, for example.

The light emitting pattern EP may be disposed on the anode AE. The light emitting pattern EP may include a light emitting layer including or consisting of a light emitting material. The light emitting pattern EP may further include a hole injection layer and a hole transport layer, which are disposed between the anode AE and the light emitting layer and also may further include an electron transport layer and an electron injection layer, which are disposed on the light emitting layer. The light emitting pattern EP may also be referred to as an 'organic layer' or an 'intermediate layer'.

The light emitting pattern EP may be patterned by the tip part defined on the partition wall PW. The light emitting pattern EP may be disposed inside the sacrificial opening OP-S, the light emitting opening OP-E, and the partition wall opening OP-P. The light emitting pattern EP may cover a portion of the top surface of the pixel defining layer PDL exposed through the partition wall opening OP-P.

The cathode CE may be disposed on the light emitting pattern EP. The cathode CE may be patterned by the tip part defined on the partition wall PW. The cathode CE may be in contact with the first inner surface SL1 of the first partition wall layer L1 and the second inner surface SL2 of the second partition wall layer L2.

The partition wall PW may receive the second driving voltage ELVSS (refer to FIG. 3B), and thus, the cathode CE may be electrically connected to the partition wall PW to receive the second driving voltage ELVSS (refer to FIG. 3B).

In an embodiment of the inventive concept, the display panel DP may further include a capping pattern CP. The capping pattern CP may be disposed in the partition wall opening OP-P and may be disposed on the cathode CE. The capping pattern CP may be patterned by the tip part disposed on the partition wall PW.

Although FIG. 6 illustrates the structure in which the capping pattern CP is not in contact with the second inner surface SL2 of the second partition wall layer L2, the embodiment of the inventive concept is not limited thereto. In an embodiment, the capping pattern CP may be in contact with the second inner surface SL2 of the second partition wall layer L2, for example. In another embodiment of the inventive concept, the capping pattern CP may be omitted.

Dummy patterns DMP may be disposed on the partition wall PW. The dummy patterns DMP may include a first dummy pattern D1, a second dummy pattern D2, and a third dummy pattern D3. The first to third dummy patterns D1, D2, and D3 may be sequentially laminated in the third direction DR3 on the top surface of the third partition wall layer L3 of the partition wall PW.

The first dummy pattern D1 may include or consist of an organic material. In an embodiment, the first dummy pattern D1 may include or consist of the same material as that of the light emitting pattern EP, for example. The first dummy pattern D1 may be simultaneously formed together with the light emitting pattern EP through one process or may be formed separately from the light emitting pattern EP by the undercut shape of the partition wall PW.

The second dummy pattern D2 may include or consist of a conductive material. In an embodiment, the second dummy pattern D2 may include or consist of the same material as that of the cathode CE, for example. The second dummy pattern D2 may be simultaneously formed together with the cathode CE through one process or may be formed separately from the cathode CE by the undercut shape of the partition wall PW.

The third dummy pattern D3 may include or consist of the same material as that of the capping pattern CP. The third dummy pattern D3 may be simultaneously formed together with the capping pattern CP through one process or may be formed separately from the capping pattern CP by the undercut shape of the partition wall PW.

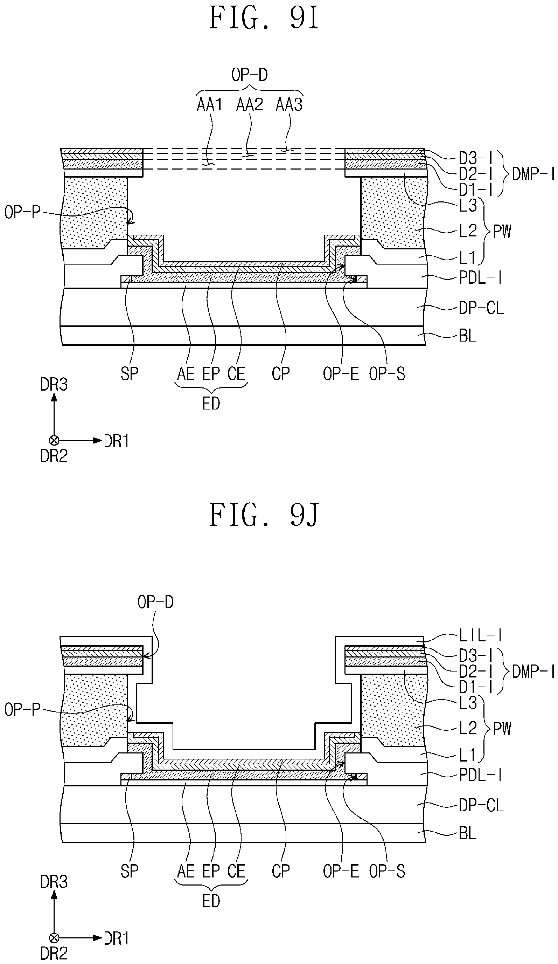

Dummy openings OP-D may be defined in the dummy patterns DMP. The dummy opening OP-D may correspond to the light emitting opening OP-E. The dummy opening OP-D may include first to third areas AA1, AA2, and AA3 (refer to FIG. 9I) that are sequentially arranged in the third direction DR3. The first area AA1 of the dummy opening OP-D may be defined by an inner surface of the first dummy pattern D1, the second area AA2 may be defined by an inner surface of the second dummy pattern D2, and the third area AA3 may be defined by an inner surface of the third dummy pattern D3. On the plane, each of the first to third dummy patterns D1, D2, and D3 may have a closed-line shape surrounding the emission area PXA.

Although FIG. 6 illustrates the structure in which the inner surfaces of the first to third dummy patterns D1, D2, and D3 and the third inner surface SL3 of the third partition wall layer L3 are aligned, the embodiment of the inventive concept is not limited thereto. In an embodiment, the first to third dummy patterns D1, D2, and D3 may cover the third inner surface SL3 of the third partition wall layer L3, for example.

The thin film encapsulation layer TFE may be disposed on the display element layer DP-OLED. The thin film encapsulation layer TFE may include a lower encapsulation inorganic pattern LIL, an encapsulation organic layer OL, and an upper encapsulation inorganic layer UIL.

The lower encapsulation inorganic pattern LIL may correspond to the light emitting opening OP-E. The lower encapsulation inorganic pattern LIL may cover the light emitting element ED and the dummy patterns DMP, and a portion of the lower encapsulation inorganic pattern LIL may be disposed inside the partition wall opening OP-P. In an embodiment, the lower encapsulation inorganic pattern LIL may be in contact with each of the first inner surface SL1 of the first partition wall layer L1 and the second inner surface SL2 of the second partition wall layer L2.

The encapsulation organic layer OL may cover the lower encapsulation inorganic pattern LIL and provide a flat top surface. The upper encapsulation inorganic layer UIL may be disposed on the encapsulation organic layer OL.

The lower encapsulation inorganic pattern LIL and the upper encapsulation inorganic layer UIL may protect the display element layer DP-OLED from moisture/oxygen, and the encapsulation organic layer OL may protect the display element layer DP-OLED from foreign substances such as dust particles.

FIG. 8 is a cross-sectional view of an embodiment of the display panel according to the inventive concept. FIG. 8 is a cross-sectional view taken along line II-II' of FIG. 5. FIG. 8 is an enlarged view illustrating one first emission area PXA-R, one second emission area PXA-G, and one third emission area PXA-B, and the descriptions of the emission area PXA of FIG. 6 may be equally applied to each of the first to third emission areas PXA-R, PXA-G, and PXA-B.

Referring to FIG. 8, the display panel DP according to this embodiment may include a base layer BL, a circuit element layer DP-CL, a display element layer DP-OLED, and an encapsulation layer TFE. The display element layer DP-OLED may include light emitting elements ED1, ED2, and ED3, sacrificial patterns SP1, SP2, and SP3, a pixel defining layer PDL, a partition wall PW, and dummy patterns DMP.

The light emitting elements ED1, ED2, and ED3 may include a first light emitting element ED1, a second light emitting element ED2, and a third light emitting element ED3. The first light emitting element ED1 may include a first anode AE1, a first light emitting pattern EP1, and a first cathode CE1. The second light emitting element ED2 may include a second anode AE2, a second light emitting pattern EP2, and a second cathode CE2. The third light emitting element ED3 may include a third anode AE3, a third light emitting pattern EP3, and a third cathode CE3. The first to third anodes AE1, AE2, and AE3 may be provided in a plurality of patterns. In an embodiment, the first light emitting pattern EP1 may provide red light, the second light emitting pattern EP2 may provide green light, and the third light emitting pattern EP3 may provide blue light.

First to third light emitting openings OP1-E, OP2-E, and OP3-E may be defined in the pixel defining layer PDL. The first light emitting opening OP1-E may expose at least a portion of the first anode AE1. The first emission area PXA-R may be defined as an area exposed by the first light emitting opening OP1-E on a top surface of the first anode AE1. The second light emitting opening OP2-E may expose at least a portion of the second anode AE2. The second emission area PXA-G may be defined as an area exposed by the second light emitting opening OP2-E on a top surface of the second anode AE2. The third light emitting opening OP3-E may expose at least a portion of the third anode AE3. The third light-emitting area PXA-B may be defined as an area exposed by the third light-emitting opening OP3-E on a top surface of the third anode AE3.

The sacrificial pattern SP may include a first sacrificial pattern SP1, a second sacrificial pattern SP2, and a third sacrificial pattern SP3. The first to third sacrificial patterns SP1, SP2, and SP3 may be disposed on top surfaces of the first to third anodes AE1, AE2, and AE3, respectively. First to third sacrificial openings OP1-S, OP2-S, and OP3-S corresponding to the first to third light emitting openings OP1-E, OP2-E, and OP3-E, respectively may be defined in the first to third sacrificial patterns SP1, SP2, and SP3.

In this embodiment, the first to third partition wall openings OP1-P and OP2-P, and OP3-P corresponding to the first to third light emitting openings OP1-E, OP2-E and OP3-E, respectively may be defined in the partition wall PW. Each of the first to third partition wall openings OP1-P, OP2-P, and OP3-P may include the first area A1 (refer to FIG. 6) and the second area A2 (refer to FIG. 6), which are described above with reference to FIG. 6. The first partition wall layer L1 may include first inner surfaces SL1 (refer to FIG. 6) defining portions of the first areas A1 of the first to third partition wall openings OP1-P, OP2-P, and OP3-P. The second partition wall layer L2 may include second inner surfaces SL2 (refer to FIG. 6) defining other portions of the first areas A1 of the first to third partition wall openings OP1-P, OP2-P, and OP3-P. The third partition wall layer L3 may include third inner surfaces SL3 (refer to FIG. 6) defining the second areas A2 of the first to third partition wall openings OP1-P, OP2-P, and OP3-P.

The first light emitting pattern EP1 and the first cathode CE1 may be disposed in the first partition wall opening OP1-P, the second light emitting pattern EP2 and the second cathode CE2 may be disposed in the second partition wall opening OP2-P, and the third light emitting pattern EP3 and the third cathode CE3 may be disposed in the third partition wall opening OP3-P. The first to third cathodes CE1, CE2, and CE3 may be in contact with the first inner surfaces SL1 of the first partition wall layer L1, respectively.

In this embodiment, the first to third cathodes CE1, CE2, and CE3 may be physically separated from each other by the second partition wall layer L2 and the third partition wall layer L3, which form the tip part so as to be disposed in the light emitting openings OP1-E, OP2-E, and OP3-E, respectively, and also may be in contact with the first partition wall layer L1 so as to be electrically connected to each other so that a common voltage is applied thereto. The first partition wall layer L1 and the second partition wall layer L2, which are in contact with the first to third cathodes CE1, CE2, and CE3, respectively, have relatively higher electrical conductivity than that of the third partition wall layer L3, and thus, contact resistance with the first to third cathodes CE1, CE2, and CE3 may be reduced. Thus, a common cathode voltage may be uniformly provided to the emission areas PXA-R, PXA-G, and PXA-B.

According to the inventive concept, the plurality of light emitting patterns EP1, EP2, and EP3 may be patterned and deposited in pixel units by the tip parts defined on the partition walls PW. That is, the plurality of light emitting patterns EP1, EP2, and EP3 may be commonly formed using an open mask, but may be easily divided into pixel units by the partition wall PW.

When patterning the plurality of light emitting patterns EP1, EP2, and EP3 using a fine metal mask ("FMM"), a support spacer protruding from the conductive partition wall for supporting the fine metal mask has to be provided. In addition, since the fine metal mask is spaced apart from the base surface, on which the patterning is performed, by heights of the partition wall and the spacer, implementation of relatively high resolution may be limited. In addition, as the fine metal mask is in contact with the spacer, foreign substances may remain on the spacer after the patterning process of the plurality of light emitting patterns EP1, EP2, and EP3, or the spacer may be damaged by being stabbed by the fine metal mask. Thus, defective display panels may occur.

According to this embodiment, the physical separation between the light emitting elements ED1, ED2, and ED3 may be easily achieved by providing the partition wall PW. Thus, current leakage or driving errors between the adjacent emission areas PXA-R, PXA-G, and PXA-B are prevented from occurring, and independent driving of each of the light emitting elements ED1, ED2, and ED3 may be possible.

Particularly, the plurality of light emitting patterns EP1, EP2, and EP3 may be patterned without a mask that is in contact with the internal configuration within the display area DA (refer to FIG. 1B) to reduce the defect rate, thereby providing the display panel DP having improved process reliability. As the patterning is possible even when the separate support spacer protruding from the partition wall PW is not provided, each of the emission areas PXA-R, PXA-G, and PXA-B may be miniaturized to provide the display panel DP in which relatively high resolution is capable of being easily implemented.

In addition, in manufacturing the large-area display panel DP, the process cost may be reduced by omitting the process of manufacturing the large-area mask, and defects that may occur in the large-area mask may not be affected, and thus, the display panel DP with improved process reliability may be provided.

The capping patterns CP1, CP2, and CP3 may include a first capping pattern CP1, a second capping pattern CP2, and a third capping pattern CP3. The first to third capping patterns CP1, CP2, and CP3 may be disposed on the first to third cathodes CE1, CE2, and CE3, respectively, and also may be disposed in the first to third partition wall openings OP1-P and OP2 -P, and OP3-P.

The dummy patterns DMP may include a plurality of first dummy patterns D1, a plurality of second dummy patterns D2, and a plurality of third dummy patterns D3.

The first dummy patterns D1 may include first-1 to first-3 dummy patterns D11, D12, and D13, which surround the first to third emission areas PXA-R, PXA-G, and PXA-B on the plane, respectively. The first-1 to first-3 dummy patterns D11, D12, and D13 may include or consist of the same material as that of the first to third light-emitting patterns EP1, EP2, and EP3, respectively, and thus may be formed through the same process as the first to third light-emitting patterns EP1, EP2, and EP3.

The second dummy patterns D2 may include second-1 to second-3 dummy patterns D21, D22, and D23, which surround the first to third emission areas PXA-R, PXA-G, and PXA-B on the plane, respectively. The second-1 to second-3 dummy patterns D21, D22, and D23 may include the same material as that of the first to third cathodes CE1, CE2, and CE3, respectively, and thus may be formed through the same process as the first to third cathodes CE1, CE2, and CE3.

The third dummy patterns D3 may include the third-1 to third-3 dummy patterns D31, D32, and D33, which surround the first to third emission areas PXA-R, PXA-G, and PXA-B on the plane, respectively. The third-1 to third-3 dummy patterns D31, D32, and D33 may include or consist of the same material as that of the first to third capping patterns CP1, CP2, and CP3, respectively, and thus may be formed through the same process as the first to third capping patterns CP1, CP2, and CP3.

The first to third dummy openings OP1-D, OP2-D, and OP3-D respectively corresponding to the first to third light-emitting openings OP1-E, OP2-E, and OP3-E may be defined in the dummy pattern DMP. Each of the first to third dummy openings OP1-D, OP2-D, and OP3-D may include first to third areas AA1, AA2, and AA3 (refer to FIG. 10J) that are sequentially arranged in the third direction DR3. The first dummy opening OP1-D may be defined by inner surfaces of the first-1, second-1, and third-1 dummy patterns D11, D21, and D31, the second dummy opening OP2 -D may be defined by inner surfaces of the first-2, second-2, and third-2 dummy patterns D12, D22, and D32, and the third dummy opening OP3-D may be defined by inner surfaces of the first-3, second-3, and third-3 dummy patterns D13, D23, and D33.

The thin film encapsulation layer TFE may include lower encapsulation inorganic patterns LIL1, LIL2, and LIL3, an encapsulation organic layer OL, and an upper encapsulation inorganic layer UIL. In this embodiment, the lower encapsulation inorganic patterns LIL1, LIL2, and LIL3 may include a first lower encapsulation inorganic pattern LIL1, a second lower encapsulation inorganic pattern LIL2, and a third lower encapsulation inorganic pattern LIL3. The first to third lower encapsulation inorganic patterns LIL1, LIL2, and LIL3 may correspond to the first to third light-emitting openings OP1-E, OP2-E, and OP3-E, respectively.

The first lower encapsulation inorganic pattern LIL1 may cover the first light emitting element ED1 and the first-1, second-1, and third-1 dummy patterns D11, D21, and D31 so that a portion of the first lower encapsulation inorganic pattern LIL1 is disposed inside the first partition wall opening OP1-P. The second lower encapsulation inorganic pattern LIL2 may cover the second light emitting element ED2 and the first-2, second-2, and third-2 dummy patterns D12, D22, and D32, so that a portion of the second lower encapsulation inorganic pattern LIL2 is disposed inside the second partition wall openings OP2-P. The third lower encapsulation inorganic pattern LIL3 may cover the third light emitting element ED3 and the first-3, second-3, and third-3 dummy patterns D13, D23, and D33 so that a portion of the third lower encapsulation inorganic pattern LIL3 is disposed inside the third partition wall opening OP3-P. The first to third lower encapsulation inorganic patterns LIL1, LIL2, and LIL3 may be provided in the form of patterns spaced apart from each other.

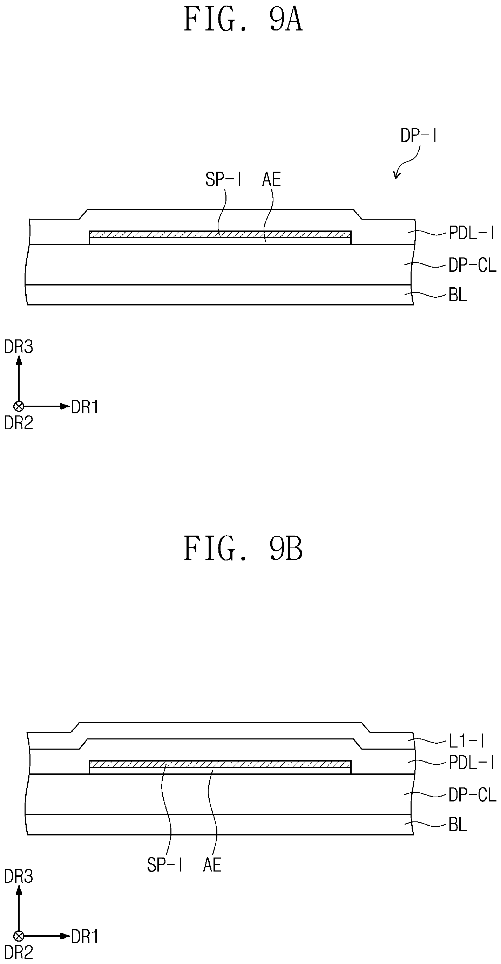

FIGS. 9A to 9I are cross-sectional views illustrating some processes of a method for manufacturing a display panel according to the inventive concept. In description of FIGS. 9A to 9L, the same/similar reference numerals are used for the same/similar components with reference to FIGS. 1A to 8, and duplicated descriptions will be omitted.

A method for manufacturing a display panel in an embodiment of the inventive concept may include a process of providing a preliminary display panel including a base layer, an anode disposed on the base layer, a pixel defining layer disposed on the base layer and defining a light emitting opening through which a portion of the anode is exposed, a process of forming a first preliminary partition wall layer including or consisting of indium zinc oxide on the preliminary display panel, a process of forming a second preliminary partition wall layer including or consisting of molybdenum-tantalum alloy oxide on the first preliminary partition wall layer, a process of forming a third preliminary partition wall layer including or consisting of aluminum oxide on the second preliminary partition wall layer, a process of etching the first to third preliminary partition wall layers to form a partition wall in which a partition wall opening is defined, and a process of forming a light emitting pattern and a cathode that is in contact with the partition wall in the partition wall opening.

Referring to FIG. 9A, the method for manufacturing the display panel according to this embodiment may include a process of providing a preliminary display panel DP-I. The preliminary display panel DP-I provided in this embodiment may include a base layer BL, a circuit element layer DP-CL, an anode AE, a preliminary sacrificial pattern SP-I, and a preliminary pixel defining layer PDL-I.

The circuit element layer DP-CL may be formed through a process of manufacturing a typical circuit element in which an insulating layer, a semiconductor layer, and a conductive layer are formed through a method such as coating or deposition and then are selectively patterned by a photolithography and etching process to form a semiconductor pattern, a conductive pattern, a signal line, and the like.

The anode AE and the preliminary sacrificial pattern SP-I may be formed by the same patterning process. The preliminary pixel defining layer PDL-I may cover both the anode AE and the preliminary sacrificial pattern SP-I.

Thereafter, referring to FIG. 9B, the method for manufacturing the display panel according to this embodiment may include a process of forming a first preliminary partition wall layer L1-I on the preliminary pixel defining layer PDL-I. The process of forming the first preliminary partition wall layer L1-I may be performed through a deposition process using a conductive material. In this embodiment, the conductive material forming the first preliminary partition wall layer L1-I may include a low-resistance metal. In an embodiment, the conductive material forming the first preliminary partition wall layer L1-I may include gold (Au), silver (Ag), aluminum (Al), magnesium (Mg), lithium (Li), molybdenum (Mo), copper (Cu), or an alloy thereof, for example. The conductive material forming the first preliminary partition wall layer L1-I may be aluminum (Al).

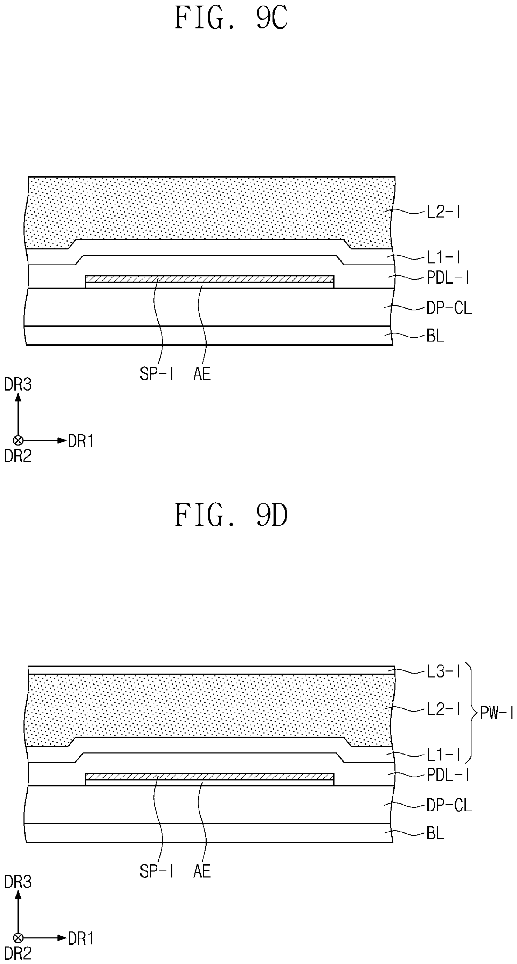

Thereafter, referring to FIG. 9C, the method for manufacturing the display panel according to this embodiment may include a process of forming a second preliminary partition wall layer L2-I on the first preliminary partition wall layer L1-I. The process of forming the second preliminary partition wall layer L2-I may be performed through a deposition process using a conductive material. In this embodiment, the conductive material forming the second preliminary partition wall layer L2-I may include a conductive inorganic material. In an embodiment, the conductive material forming the second preliminary partition wall layer L2-I may be at least one of amorphous carbon, polycrystalline silicon, or n-type silicon, for example.

Then, referring to FIG. 9D, the method for manufacturing the display panel according to this embodiment may include a process of forming a third preliminary partition wall layer L3-I on the second preliminary partition wall layer L2-I to form a preliminary partition wall PW-I. The process of forming the third preliminary partition wall layer L3-I may be performed through a deposition process using a conductive material. In this embodiment, the conductive material forming the third preliminary partition wall layer L3-I may be a metal material. In an embodiment, the conductive material forming the third preliminary partition wall layer L3-I may include gold (Au), silver (Ag), aluminum (Al), magnesium (Mg), lithium (Li), molybdenum (Mo), titanium (Ti), copper (Cu), or an alloy thereof, for example. The metal forming the third preliminary partition wall layer L3-I may be different from the metal forming the first preliminary partition wall layer L1-I. The metal forming the third preliminary partition wall layer L3-I may be, e.g., titanium (Ti).

The preliminary partition wall PW-I may include a first preliminary partition wall layer L1-I, a second preliminary partition wall layer L2-I, and a third preliminary partition wall layer L3-I.

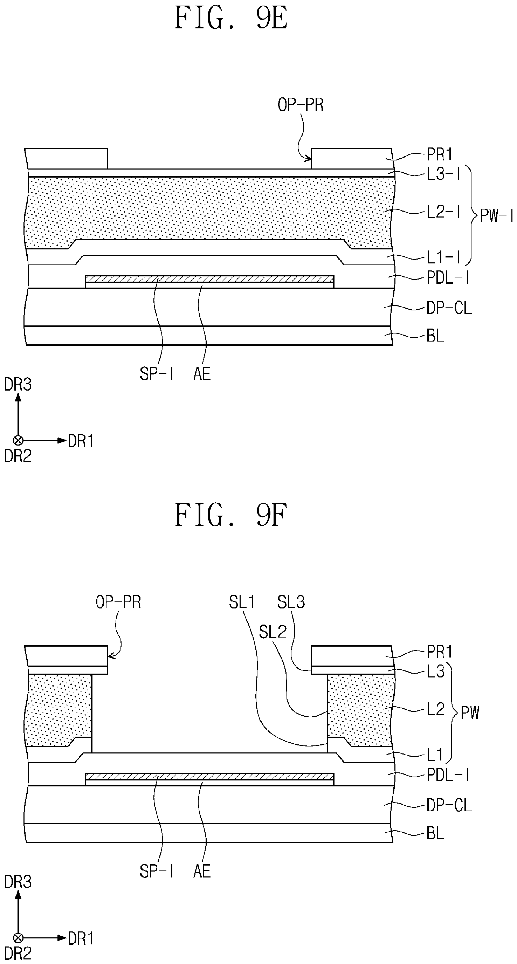

Thereafter, referring to FIG. 9E, the method for manufacturing the display panel according to this embodiment may include a process of forming a first photoresist layer PR1 on the preliminary partition wall PW-I. The first photoresist layer PR1 may be formed by forming a preliminary photoresist layer on the preliminary partition wall PW-I and then patterning the preliminary photoresist layer using a photo mask. A photo opening OP-PR overlapping the anode AE may be defined in the first photoresist layer PR1 through the patterning process.

Referring to FIG. 9F, the method for manufacturing the display panel according to this embodiment may include a process of etching the first preliminary partition wall layer L1-I, the second preliminary partition wall layer L2-I, and the third preliminary partition wall layer L3-I to form a partition wall PW from the preliminary partition wall PW-I.

The process of etching the preliminary partition wall PW-I may be performed twice. The process of etching the first preliminary partition wall layer L1-I, the second preliminary partition wall layer L2-I, and the third preliminary partition wall layer L3-I may include a primary etching process and a secondary etching process. Preferentially, a process of primarily etching the first preliminary partition wall layer L1-I, the second preliminary partition wall layer L2-I, and the third preliminary partition wall layer L3-I may include a process of performing dry etching on the first preliminary partition wall layer L1-I, the second preliminary partition wall layer L2-I, and the third preliminary partition wall layer L3-I by the first photoresist layer PR1 as a mask. Each of the first preliminary partition wall layer L1-I and the third preliminary partition wall layer L3-I may include or consist of a metal material, and the second preliminary partition wall layer L2-I may include or consist of a conductive inorganic material such as amorphous carbon, polycrystalline silicon, or n-type silicon, and thus, a primary dry etching process may be easily performed.

The primary dry etching process according to this embodiment may be performed under an etching environment in which the first preliminary partition wall layer L1-I, the second preliminary partition wall layer L2-I, and the third preliminary partition wall layer L3-I have substantially the same etching selectivity. Thus, an inner surface of the first preliminary partition wall layer L1-I, an inner surface of the second preliminary partition wall layer L2-I, and an inner surface of the third preliminary partition wall layer L3-I, which define the preliminary partition wall opening OP-PI, may be substantially aligned with each other.

The process of secondarily etching the first preliminary partition wall layer L1-I and the second preliminary partition wall layer L2-I may include a process of wet-etching the first preliminary partition wall layer L1-I and the second preliminary partition wall layer L2-I by the first photoresist layer PR1 as a mask to form a partition wall opening OP-P.

The partition wall opening OP-P may include a first area A1 and a second area A2 that are sequentially disposed in a thickness direction (i.e., the third direction DR3). The first partition wall layer L1 may include a first inner surface SL1 defining a portion of the first area A1 of the partition wall opening OP-P, and the second partition wall layer L2 may include a second inner surface SL2 defining the other portion of the first area A1. The third partition wall layer L3 may include a third inner surface SL3 defining the second area A2.

The secondary wet etching process according to this embodiment may be performed under an environment in which an etch selectivity between the first preliminary partition wall layer L1-I, the second preliminary partition wall layer L2-I, and the third preliminary partition wall layer L3-I is large. Thus, an inner surface of the partition wall PW defining the partition wall opening OP-P may have an undercut shape in cross-section. Particularly, as the etch rate of each of the first partition wall layer L1 and the second partition wall layer L2 with respect to an etching solution is greater than that of the third partition wall layer L3, the first partition wall layer L1 and the second partition wall layer L2 may be more etched than the third partition wall layer L3. Thus, a first inner surface SL1 of the first partition wall layer L1 and a second inner surface SL2 of the second partition wall layer L2 may be more recessed inward than a third inner surface SL3. A tip part may be formed on the partition wall PW due to a portion of the third partition wall layer L3 protruding toward a center of the anode AE compared to the first partition wall layer L1 and the second partition wall layer L2.

FIG. 9F illustrates the structure in which the first partition wall layer L1 and the second partition wall layer L2 are etched so that the third partition wall layer L3 forms the tip part of the partition wall PW, but is not limited thereto. In an embodiment, only the first partition wall layer L1 may be wet-etched so that each of the second partition wall layer L2 and the third partition wall layer L3 forms the tip part, or a portion of each of the first partition wall layer L1 and the second partition wall layer may be wet-etched so that each of a remaining portion of the second partition wall layer L2 and the third partition wall layer L3 forms the tip part, for example.

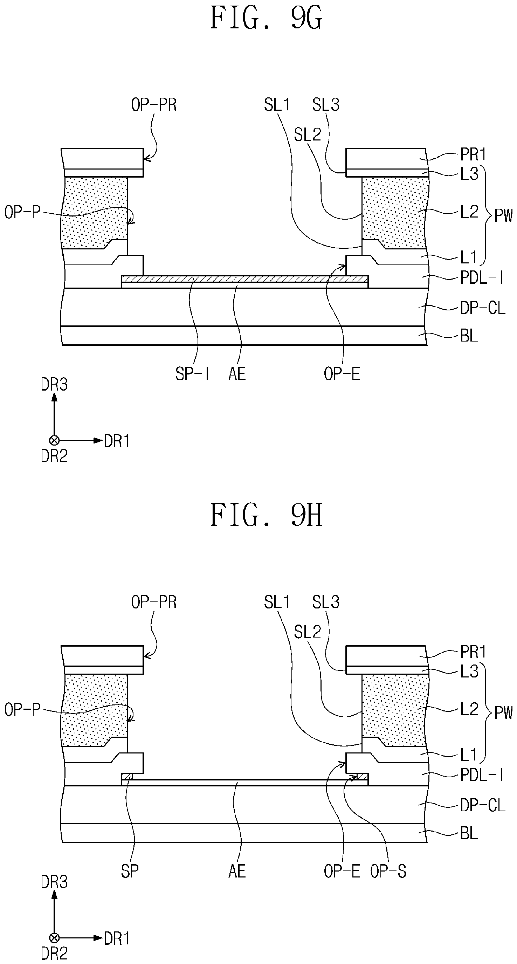

Thereafter, referring to FIG. 9G, the method for manufacturing the display panel according to this embodiment may include a process of etching the preliminary pixel defining layer PDL-I to form a pixel defining layer PDL (refer to FIG. 8). The process of etching the preliminary pixel defining layer PDL-I may be performed through a dry etching method. Here, the etching may be performed using the first photoresist layer PR1 and a portion of the partition wall PW, i.e., the third partition wall layer L3 as a mask. A light emitting opening OP-E corresponding to the partition wall opening OP-P may be defined in the pixel defining layer PDL.

Thereafter, referring to FIG. 9H, the method for manufacturing the display panel according to this embodiment may include a process of etching the preliminary sacrificial pattern SP-I. The process of etching the preliminary sacrificial pattern SP-I may be performed through a wet etching method. Here, the etching may be performed using the first photoresist layer PR1 and a portion of the partition wall PW, i.e., the third partition wall layer L3 as a mask.

A sacrificial opening OP-S overlapping the light emitting opening OP-E may be defined in the sacrificial pattern SP formed by etching the preliminary sacrificial pattern SP-I. At least a portion of the anode AE may be exposed from the sacrificial pattern SP and the pixel defining layer PDL by the sacrificial opening OPS and the light emitting opening OP-E. The sacrificial pattern SP may include an amorphous transparent conductive oxide. In an embodiment, the sacrificial pattern SP may be zinc oxide (ZnOx) doped with aluminum (Al), for example.

The process of etching the sacrificial pattern SP may be performed under an environment in which etching selectivity between the sacrificial pattern SP and the anode AE is high, and thus, the sacrificial pattern SP may be prevented from being etched together with the anode AE. That is, the sacrificial pattern SP having a etch rate greater than that of the anode AE may be disposed between the pixel defining layer PDL and the anode AE to prevent the sacrificial pattern SP from being etched together with the anode AE during the etching process.

In addition, the process of etching the sacrificial pattern SP may be performed under an environment in which etching selectivity between the sacrificial pattern SP and the first and second partition wall layers L1 and L2 of the partition wall PW is high, and thus, the sacrificial pattern SP may be prevented from being etched together with the first second partition wall layers L1 and L2.

Referring to FIG. 9I, the method for manufacturing the display panel according to this embodiment may include a process of forming a light emitting pattern EP after removing the first photoresist layer PR1, a process of forming a cathode CE, and a process of forming a capping pattern CP. The light emitting pattern ED may include the cathode CE. Forming a light emitting pattern ED may comprise forming a cathode CE.

Each of the process of forming the light emitting pattern EP, the process of forming the cathode CE, and the process of forming the capping pattern CP may be performed through a deposition process. In an embodiment, the process of forming the light emitting pattern EP may be performed through a thermal evaporation process, the process of forming the cathode CE may be performed through a sputtering process, and the process of forming the capping pattern CP may be performed through a thermal evaporation process. However, the invention is not limited thereto.

In the process of forming the light emitting pattern EP, the light emitting pattern EP may be separated by the tip part formed on the partition wall PW and disposed in the light emitting opening OP-E and the partition wall opening OP-P. In the process of forming the light emitting pattern EP, the first preliminary dummy pattern D1-I spaced apart from the light emitting pattern EP may be formed together on the partition wall PW.

In the process of forming the cathode CE, the cathode CE may be separated by the tip part formed on the partition wall PW and disposed in the partition wall opening OP-P. The cathode CE may be provided at an incident angle greater than that of the light emitting pattern EP, and thus, the cathode CE may be in contact with the first inner surface SL1 of the first partition wall layer L1. In the process of forming the cathode CE, the second preliminary dummy pattern D2-I spaced apart from the cathode CE may be formed together on the partition wall PW. The anode AE, the light emitting pattern EP, and the cathode CE may constitute the light emitting element ED.

In the process of forming the capping pattern CP, the capping pattern CP may be separated by the tip part formed on the partition wall PW and disposed in the partition wall opening OP-P. In the process of forming the capping pattern CP, the third preliminary dummy pattern D3-I spaced apart from the capping pattern CP may be formed together on the partition wall PW. In another embodiment of the inventive concept, the process of forming the capping pattern CP may be omitted.

The first to third preliminary dummy patterns D1-I, D2-I, and D3-I may form a preliminary dummy pattern DMP-I, and a dummy opening OP-D may be defined in the preliminary dummy pattern DMP-I. The dummy opening OP-D may include a first area AA1, a second area AA2, and a third area AA3 that are sequentially disposed in the thickness direction (i.e., in the third direction DR3). The first area AA1 of the dummy opening OP-D may be defined by an inner surface of the first dummy pattern D1, the second area AA2 may be defined by an inner surface of the second dummy pattern D2, and the third area AA3 may be defined by an inner surface of the third dummy pattern D3.

Referring to FIG. 9J, the method for manufacturing the display panel according to this embodiment may include a process of forming a preliminary lower encapsulation inorganic pattern LIL-I. The preliminary lower encapsulation inorganic pattern LIL-I may be formed through a deposition process. In an embodiment, the preliminary lower encapsulation inorganic pattern LIL-I may be formed through a chemical vapor deposition (CVD) process. The preliminary lower encapsulation inorganic pattern LIL-I may be formed on the partition wall PW and the cathode CE, and a portion of the preliminary lower encapsulation inorganic pattern LIL-I may be formed inside the partition wall opening OP-P.

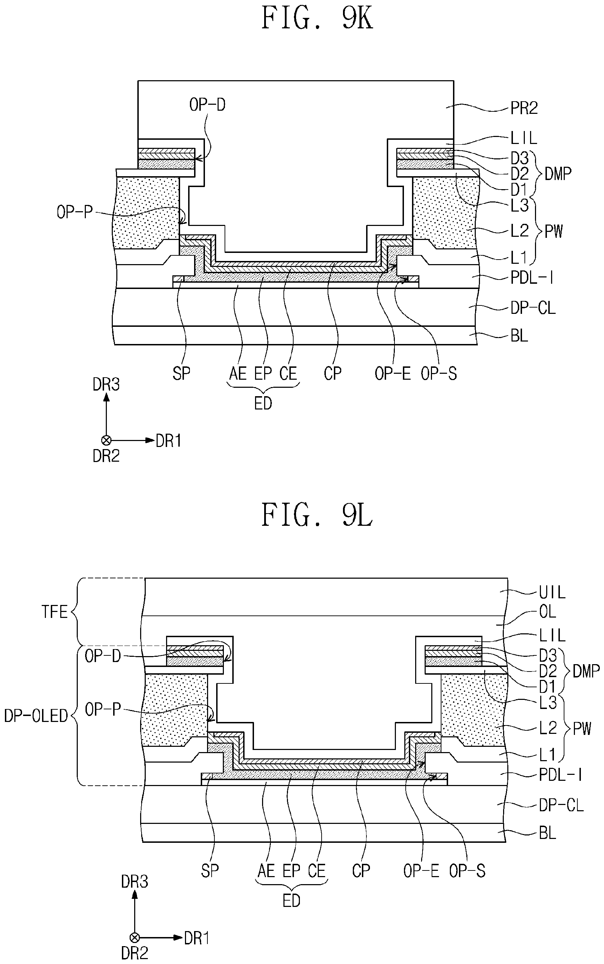

Thereafter, referring to FIG. 9K, the method for manufacturing the display panel according to this embodiment includes a process of forming a second photoresist layer PR2, a process of patterning the preliminary lower encapsulation inorganic pattern LIL-I (refer to FIG. 9J) to from a lower encapsulation inorganic pattern LIL, and a process of patterning the preliminary dummy patterns DMP-I (refer to FIG. 9J) to form dummy patterns DMP.

In the process of forming the second photoresist layer PR2, the second photoresist layer PR2 may be formed by forming a preliminary photoresist layer and then patterning the preliminary photoresist layer using a photo mask. The second photoresist layer PR2 may be formed in the form of a pattern corresponding to the light emitting openings OP-E through the patterning process.

In the process of patterning the preliminary lower encapsulation inorganic pattern LIL-I, the preliminary lower encapsulation inorganic pattern LIL-I may be dry-etched to be patterned so that a portion of the preliminary lower encapsulation inorganic pattern LIL-I, which overlaps the remaining anodes expect for the corresponding anode AE is removed. In an embodiment, when the preliminary lower encapsulation inorganic pattern LIL-I corresponds to the first anode AE1 (refer to FIG. 8), a portion of the preliminary lower encapsulation inorganic pattern LII,-I, which overlaps the second and third anodes AE2 and AE3 (refer to FIG. 8) may be removed, for example.

A lower encapsulation inorganic pattern LIL overlapping the corresponding light emitting opening OP-E may be formed from the patterned preliminary lower encapsulation inorganic pattern LIL-I. A portion of the lower encapsulation inorganic patterns LIL may be disposed within the partition wall opening OP-P to cover the light emitting element ED, and the other portion of the lower encapsulation inorganic pattern LIL may be disposed on the partition wall PW.

In the process of patterning the preliminary dummy patterns DMP-I, the first to third preliminary dummy patterns D1-I, D2-I, and D3-I may be dry-etched to be patterned so that portions of the first to third preliminary dummy patterns D1-I, D2-I, and D3-I, which overlap the remaining anodes except for the corresponding anode AE, may be removed. In an embodiment, when the first to third preliminary dummy patterns D1-I, D2-I, and D3-I correspond to the first anode AE1 (refer to FIG. 8), portions of the first to third preliminary dummy patterns D1-I, D2-I, and D3-I, which overlap the second and third anodes AE2 and AE3 (refer to FIG. 8) may be removed, for example.

The first to third dummy patterns D1, D2, and D3 overlapping the corresponding light emitting openings OP-E may be formed from the patterned first to third preliminary dummy patterns D1-I, D2-I, and D3-I to form dummy patterns DMP including the first to third dummy patterns D1, D2, and D3. Each of the first to third dummy patterns D1, D2, and D3 may have a closed-line shape surrounding the corresponding emission area PXA (refer to FIG. 5) on the plane.

Referring to FIG. 9L, the method for manufacturing the display panel according to this embodiment may include a process of forming an encapsulation organic layer OL and an upper encapsulation inorganic layer UIL after removing the second photoresist layer PR2 (refer to FIG. 9K) to complete the display panel DP. The encapsulation organic layer OL may be formed by applying an organic material through an inkjet method, but is not limited thereto. The encapsulation organic layer OL provides a planarized top surface. Then, the upper encapsulation inorganic layer UIL may be formed by depositing an inorganic material. As a result, the display panel DP including the base layer BL, the circuit element layer DP-CL, the display element layer DP-OLED, and the thin film encapsulation layer TFE may be formed.

A process of forming a partition wall opening and a light emitting opening, which correspond to light emitting areas having different colors in the partition wall PW and the pixel defining layer PDL, a process of forming light emitting elements providing different colors, and a process of forming a lower encapsulation inorganic pattern covering light emitting elements providing the different colors may be further performed between the process of forming the lower encapsulation inorganic pattern LIL and the process of completing the display panel DP. As a result, as illustrated in FIG. 8, the display panel DP including the first to third light emitting elements ED1, ED2, and ED3, the first to third capping patterns CP1, CP2, and CP3, the first-1 to first-3 dummy patterns D1-1, D1-2, D1-3, the second-1 to second-3 dummy patterns D2-1, D2-2, D2-3, the third-1 to third-3 dummy patterns D3-1, D3-2, and D3-3, and the first to third lower encapsulation inorganic patterns LIL1, LIL2, and LIL3 may be formed.

According to the display panel in the embodiment of the inventive concept, the light emitting patterns may be disposed on the emission areas so as to be separated from each other by the partition walls, each of which has the undercut shape, respectively, and the partition wall may include the plurality of partition wall layers. Here, the body part of the partition wall, which has the thickest thickness, may include or consist of the conductive inorganic material having relatively low reactivity with oxygen so that the oxide layer is not disposed thereon, and thus, the defects such as the increase in contact resistance due to the formation of the oxide layer may be prevented from occurring. Therefore, the driving reliability and stability of the display panel including the partition wall may be improved.

It will be apparent to those skilled in the art that various modifications and variations may be made in the inventive concept. Thus, it is intended that the disclosure covers the modifications and variations of this invention provided they come within the scope of the appended claims and their equivalents. Therefore, the technical scope of the invention is not limited to the contents described in the detailed description of the specification, but should be determined by the claims.

## Claims

1. A display panel comprising:
a base layer;
a pixel defining layer which is disposed on the base layer and in which a light emitting opening is defined;
a partition wall which is disposed on the pixel defining layer and in which a partition wall opening corresponding to the light emitting opening is defined, the partition wall comprising:
a first partition wall layer disposed on the pixel defining layer and including a metal; and
a second partition wall layer disposed on the first partition wall layer and including at least one of amorphous carbon, polycrystalline silicon, or n-type silicon; and
a light emitting element comprising an anode, an intermediate layer, and a cathode which is in contact with the partition wall, the light emitting element being disposed in the partition wall opening.

2. The display panel of claim 1, wherein the partition wall further comprises a third partition wall layer disposed on the second partition wall layer and including a metal or a silicon-based compound.

3. The display panel of claim 2, wherein the third partition wall layer includes titanium.

4. The display panel of claim 2, wherein the third partition wall layer includes at least one of silicon oxide, silicon nitride, or silicon oxynitride.

5. The display panel of any of claims 2 to 4, wherein the partition wall opening comprises:
a first area on which the light emitting element is disposed; and
a second area having a width less than a width of the first area,
wherein an inner surface of the second partition wall layer defines the first area, and
an inner surface of the third partition wall layer defines the second area.

6. The display panel of any of claims 2 to 5, wherein the third partition wall layer has an undercut shape protruding from one side of the second partition wall layer.

7. The display panel of any preceding claim, wherein the first partition wall layer has a thickness of about 1,000 angstroms or more and about 2,500 angstroms or less, and
the second partition wall layer has a thickness of about 4,000 angstroms or more and about 5,000 angstroms or less.

8. The display panel of any preceding claim, wherein the first partition wall layer includes aluminum.

9. The display panel of any preceding claim, wherein the first partition wall layer is directly disposed on the pixel defining layer, and
the second partition wall layer is directly disposed on the first partition wall layer.

10. The display panel of any preceding claim, wherein the second partition wall layer comprises a first sub partition wall layer and a second sub partition wall layer disposed on the first sub partition wall layer, and
the partition wall further comprises an intermediate inorganic layer disposed between the first sub partition wall layer and the second sub partition wall layer.

11. The display panel of any preceding claim, further comprising a sacrificial pattern which is disposed between the anode and the pixel defining layer and in which a sacrificial opening overlapping the light emitting opening is defined.

12. The display panel of any preceding claim, wherein the cathode is in contact with the second partition wall layer.

13. The display panel of any preceding claim, further comprising a thin film encapsulation layer disposed on the light emitting element and comprising a plurality of thin films,
wherein the thin film encapsulation layer comprises an encapsulation inorganic pattern which covers the light emitting element and of which a portion is in contact with the partition wall.

14. The display panel of any preceding claim, wherein an inner surface of the first partition wall layer and an inner surface of the second partition wall layer are aligned.

15. A method for manufacturing a display panel, the method comprising:
providing a preliminary display panel comprising a base layer, an anode disposed on the base layer, a pixel defining layer disposed on the base layer and defining a light emitting opening through which a portion of the anode is exposed;
forming a first preliminary partition wall layer including a metal on the preliminary display panel;
forming a second preliminary partition wall layer including at least one of amorphous carbon, polycrystalline silicon, or n-type silicon on the first preliminary partition wall layer;
forming a third preliminary partition wall layer including a metal or a silicon-based compound on the second preliminary partition wall layer;
etching the first to third preliminary partition wall layers and forming a partition wall in which a partition wall opening is defined; and
forming a light emitting pattern and a cathode which is in contact with the partition wall in the partition wall opening.
